# EUROPEAN PATENT APPLICATION

(11) **EP 4 579 744 A1**
(43) Date of publication of application: **02.07.2025**
(21) Application number: 23857774.6
(22) Date of filing: 25.08.2023
(51) Int. Cl.: H01L 25/075, H01L 25/16, H01L 33/48, H01L 33/54, H01L 33/56, H01L 33/50, H01L 33/62, G09G 3/32

(54) **LIGHT-EMITTING DIODE MODULE AND SYSTEM COMPRISING SAME**

(30) Priority: 26.08.2022 US 202263401436 P; 11.11.2022 US 202263424634 P; 21.08.2023 US 202318452733
(71) Applicant: Seoul Semiconductor Co., Ltd., Gyeonggi-do 15429 (KR)
(72) Inventor: KWAK, Meen Woo, Ansan-Si Gyeonggi-do 15429 (KR); HWANG, Sung Ki, Ansan-Si Gyeonggi-do 15429 (KR)
(74) Representative: Stolmár & Partner Patentanwälte PartG mbB
(86) International application number: PCT/KR2023/012620
(87) International publication number: WO 2024/043742

(57) **Abstract**

A light-emitting diode module according to one embodiment comprises a first substrate and a second substrate positioned in one direction of the first substrate, wherein the first substrate includes a light-emitting diode package on which at least one light-emitting unit for generating and emitting light is disposed, the light-emitting diode package includes a dam portion for encompassing the light-emitting unit, and the first substrate and the second substrate include overlapping regions that overlap each other.

## Description

### [Technical Field]

The present disclosure relates to a light emitting diode module and a system including the same, and more particularly to a light emitting diode module and a system including the same in the fields related to vehicle headlamps and displays.

### [Background Art]

A light emitting diode is an inorganic semiconductor device that emits light generated through recombination of electrons and holes, and has been recently used in various fields such as display apparatuses, automobile lamps, general lighting, and others. Since the light emitting diode has a long lifespan, low power consumption, and fast response speed, a light emitting apparatus including the light emitting diodes is expected to replace a conventional light source. In particular, the light emitting diode has been in the spotlight as the light source for the vehicular lamp that can be used in small sizes.

In addition, as the development of autonomous cars becomes active, the development of vehicular head lamps that implement smart lamp lighting by calculating a distance to other vehicles using a front camera or laser is also becoming active by applying Adaptive Driving Beam (ADB) technology. The ADB technology should be applied to block light only in local regions, such as vehicles ahead, and not to block light in other regions for driving safety.

However, a plurality of light emitting diodes disposed in a light emitting diode package is not individually independently driven, and when one light emitting diode is turned off, a drawback that a whole line is turned off has been reported. In addition, as the number of mounted light emitting diodes increases, the number of driving controllers of a light emitting unit for electrically connecting the light emitting diodes also increases, there is a drawback that a size of a light emitting diode module gradually increases.

As the size of the light emitting diode module increases, a size of a peripheral lighting apparatus also increases, so that space is limited. Therefore, when applied to the vehicular head lamp, it influences a vehicle design, so that there is a limitation that the vehicle design is not flexible.

### [Disclosure]

### [Technical Problem]

Exemplary embodiments provide a light emitting diode module that is configured to reduce a cross-sectional area occupied by a printed circuit board and a system including the same.

In addition, exemplary embodiments provide a light emitting module for a vehicle headlamp that can increase a flexibility of vehicle design.

### [Technical Solution]

A light emitting diode module according to an embodiment of the present disclosure includes a first substrate and a second substrate disposed in one direction of the first substrate. The first substrate may include a light emitting diode package on which at least one or more light emitting units that generate and emit light are disposed, and the light emitting diode package may include a dam portion formed to surround the light emitting unit. The first substrate and the second substrate may include an overlapping region where they overlap with each other.

The first substrate may further include a first connector for receiving external power, and the second substrate may further include a second connector electrically connected to the first substrate.

In an embodiment, the first substrate and the second substrate may be spaced apart at a predetermined interval.

In an embodiment, the light emitting diode module may further include at least one or more driving controllers that drive the light emitting diode package. The light emitting diode package and the driving controller may be disposed to overlap vertically.

The light emitting diode module may further include a fixer that connects and secures the first substrate and the second substrate.

The light emitting diode package may further include a first light control layer that fills a space between the light emitting unit and the dam portion.

The first light control layer may include a material that reflects light. An upper surface of the first light control layer may have a concave shape.

In an embodiment, the light emitting unit and the dam portion may have a same height.

In another embodiment, the height of the dam portion may have a height higher than that of the light emitting unit.

The light emitting unit may be disposed in a plural number in rows and columns to form a matrix beam.

The light emitting units arranged in the plural number may include a first light emitting unit and a second light emitting unit, and the light emitting diode module may include a second light control layer that fills a space between the first light emitting unit and the second light emitting unit.

The second light control layer may include a material that reflects light.

The first substrate and the second substrate may be disposed along a first direction, and a length of an overlapping region in the first direction may be smaller than a length of the second substrate in a second direction perpendicular to the first direction.

The first substrate and the second substrate may be disposed along the first direction, and a length of the second substrate in the first direction may be greater than a length of the second substrate in the second direction perpendicular to the first direction.

A distance between one surface of the first substrate and one surface of the second substrate opposite to the one surface in the overlapping region may be smaller than a thickness of the first substrate.

A reflectance of one surface of the first substrate may be different from that of one surface of the second substrate.

The light emitting diode module may further include an interconnector disposed in the overlapping region. The interconnector may include a conductive material.

In another embodiment of the present disclosure, a light emitting diode module may include a first substrate and a second substrate disposed under the first substrate, and may further include a third substrate disposed under the second substrate. The first substrate may include a light emitting diode package on which at least one or more light emitting units that generate and emit light are disposed, and the light emitting diode package may include a dam portion formed to surround the light emitting unit. In addition, the second substrate and the third substrate may include at least one or more driving controllers that drive the light emitting diode package, respectively.

According to an embodiment of the present disclosure, a light emitting diode module is provided, the light emitting diode module including: a plurality of printed circuit boards; a light emitting diode package disposed on any one of the plurality of printed circuit boards; a driving chip disposed on another printed circuit board on which the light emitting diode package is not disposed among the plurality of printed circuit boards; and a connector interconnecting the plurality of printed circuit boards.

A plurality of the driving chips may be separately disposed on the plurality of printed circuit boards.

The plurality of printed circuit boards may be secured in a state that they are spaced apart from one another.

The plurality of printed circuit boards may be arranged such that edges thereof are flush with one another vertically, or two or more of them may be arranged such that edges thereof form an oblique line.

Among the plurality of printed circuit boards, the printed circuit boards arranged such that edges thereof form the oblique line may be arranged such that partial areas overlap, or arranged such that there is no overlapping area.

The light emitting diode package may include a plurality of light sources arranged in a matrix array.

The plurality of light sources may be arranged in N × M (where N is greater than 1, and M is greater than N).

The light emitting diode package may further include a first molding member formed around and between the plurality of light sources.

The light emitting diode package may further include a second molding member formed to surround the first molding member with a predetermined thickness.

The light emitting diode package may further include a plurality of first through fourth electrodes disposed in a line, respectively, in which the plurality of first electrodes and the plurality of second electrodes may be disposed on opposite sides of the plurality of third electrodes and the plurality of fourth electrodes with respect to the light source.

Each of the plurality of light sources may include a light emitting diode chip; and a cover portion disposed on the light emitting diode chip.

The cover portion may have any one of side cross-sections among a trapezoidal shape with a longer upper side; a trapezoidal shape with a longer lower side; and a shape in which both upper corners of a rectangle are cut out roundly.

The light emitting diode package may further include a substrate on which the plurality of light sources is disposed; and a wire connecting the substrate and the printed circuit board.

The light emitting diode module may further include a protection member covering the wire.

A partial region of the printed circuit board may be recessed, the light emitting diode package may be disposed in a recessed region of the printed circuit board, and the protection member may be disposed in a non-recessed region of the printed circuit board.

The light emitting diode package may further include a reflection member covering the light source.

Each of the plurality of light sources may include a light emitting diode chip; and a cover portion disposed on the light emitting diode chip, in which a region disposed over the cover portion among the reflection members may be formed to have a thickness smaller than that of the cover portion.

According to another aspect of the present disclosure for achieving the above object, a vehicle headlamp system including the light emitting diode module described above is provided.

The light emitting diode module may be disposed to contact a heat sink.

According to another aspect of the present disclosure for achieving the above object, a display system including the light emitting diode module described above is provided.

### [Advantageous Effects]

According to the present disclosure, it is possible to form a small printed circuit board with a size of 1/4 or less compared to that of a prior art by separately disposing a light emitting diode package and a driving chip on different substrates.

According to the present disclosure, even when many driving chips are required to drive the light emitting diode package, it is possible to form the small printed circuit board since the driving chips can be divided and disposed on a plurality of printed circuit boards.

According to the present disclosure, by forming the plurality of printed circuit boards and arranging the plurality of printed circuit boards spaced apart, heat spread is performed through a space between the printed circuit boards, and thus, it is very favorable in terms of heat spread compared to that of the prior art that includes only one printed circuit board. When heat spread is performed smoothly, there is an advantage, in particular, that the performance of the driving chip may be improved.

According to the present disclosure, since a size of the printed circuit board may be formed as small as necessary, a degree of freedom in design may be increased and flexibility of design may be provided, and when the present disclosure is applied to a headlamp, since it is possible to reduce an area of a lens of the headlamp, a cost required for the lens may be reduced.

In addition, according to the present disclosure, the degree of freedom in design may be improved by reducing a cross-sectional area of the printed circuit board and enabling the printed circuit board to be arranged in front and rear as much as necessary.

Since the present disclosure includes a plurality of printed circuit boards, it is possible to dispose as many driving chips as needed without limiting an area of the printed circuit board. An increase in the number of driving chips has an advantage that a precision of control becomes higher.

According to the prior art including only one printed circuit board, there is no space to additionally dispose a driving chip unless the size of the printed circuit board is increased, so it is difficult to increase the number of light sources, whereas according to the present disclosure, the number of light sources may be increased sufficiently as many as needed.

### [Description of Drawings]

FIG. 1 is a schematic plan view of a light emitting diode module according to a first embodiment of the present disclosure.
FIG. 2A is a three-dimensional view of a light emitting diode module according to a second embodiment of the present disclosure.
FIG. 2B is a cross-sectional view (A-A') of the light emitting diode module according to the second embodiment of FIG. 2A.
FIG. 2C is a three-dimensional diagram of a light emitting diode module according to an exemplary embodiment of the present disclosure.
FIG. 3A is a three-dimensional view of a light emitting diode module according to a third embodiment of the present disclosure.
FIG. 3B is a cross-sectional view (B-B') of the light emitting diode module according to the third embodiment of FIG. 3A.
FIG. 3C is a three-dimensional diagram of a light emitting diode module according to an exemplary embodiment of the present disclosure.
FIG. 4A is a schematic plan view illustrating a light emitting diode package according to an embodiment of the present disclosure.
FIG. 4B is a cross-sectional view (C-C') of the light emitting diode package according to the embodiment of FIG. 4A.
FIG. 4C is a diagram showing various forms of light emitting units included in a light emitting diode package.
FIG. 5 is a schematic plan view illustrating a light emitting diode package according to exemplary embodiments of the present disclosure.
FIG. 6A is a schematic plan view illustrating a light emitting diode package according to an exemplary embodiment of the present disclosure.
FIG. 6B is a cross-sectional view (D-D') of the light emitting diode package according to the exemplary embodiment of FIG. 6A.
FIG. 6C is a cross-sectional view (D-D') of the light emitting diode package according to the exemplary embodiment of FIG. 6A.
FIG. 6D is a cross-sectional view (D-D') of the light emitting diode package according to the exemplary embodiment of FIG. 6A.
FIG. 6E is a cross-sectional view (D-D') of the light emitting diode package according to the exemplary embodiment of FIG. 6A.
FIG. 7 is a view of a light emitting diode module according to a fourth embodiment of the present disclosure.
FIG. 8 s a view of a light emitting diode module according to a fifth embodiment of the present disclosure.
FIG. 9 is a view of the light emitting diode module shown in FIG. 2 viewed from a bottom (Z direction).
FIG. 10 shows a cross-section (I-I' direction) of the light emitting diode module shown in FIG. 8 as viewed from an X direction.
FIG. 11 shows a light emitting diode module according to a sixth embodiment of the present disclosure.
FIG. 12 shows a view of the light emitting diode module shown in FIG. 11 from below (Z direction).
FIG. 13 shows a cross-section of the light emitting diode module shown in FIG. 11 (II-II' direction) viewed from the X direction.
FIG. 14 is an enlarged view of a light emitting diode package of an embodiment applied to the light emitting diode module of the present disclosure.
FIG. 15 shows a rear side of the light emitting diode package shown in FIG. 14.
FIG. 16 shows a portion of a cross section of the light emitting diode package shown in FIG. 14 cut in a lateral direction (III-III' direction).
FIG. 17 is a view of a cross section (IV-IV' direction) of the light emitting diode module shown in FIG. 14 viewed from an X direction.
FIG. 18 shows various forms of a cover portion applied to the light emitting diode module of the present disclosure.
FIG. 19 is a cross-sectional view of the light emitting diode package shown in FIG. 14 cut in the vertical direction (direction IV-IV') and shows a first embodiment of a printed circuit board.
FIG. 20 is a cross-sectional view of the light emitting diode package shown in FIG. 14 cut in the vertical direction (IV-IV' direction) and illustrates a second embodiment of the printed circuit board.
FIG. 21 is a cross-sectional view of the light emitting diode package shown in FIG. 14 cut in the vertical direction (IV-IV' direction) and illustrates a third embodiment of the printed circuit board.
FIG. 22 is a cross-sectional view of the light emitting diode package shown in FIG. 14 cut in the vertical direction (IV-IV' direction) and illustrates a fourth embodiment of the printed circuit board.
FIG. 23 is a cross-sectional view of the light emitting diode package shown in FIG. 14 cut in the vertical direction (IV-IV' direction) and illustrates a fifth embodiment of the printed circuit board.
FIG. 24 is a schematic perspective view illustrating a light emitting module according to a seventh embodiment of the present disclosure.
FIG. 25 is a schematic cross-sectional view taken along line V-V' in FIG. 24.
FIG. 26 is a schematic cross-sectional view illustrating a light emitting module according to an eighth embodiment of the present disclosure.

### [Detailed Description of the Illustrated Embodiments]

Hereinafter, embodiments of the present disclosure will be described in detail with reference to the accompanying drawings. The following embodiments are provided by way of example so as to fully convey the spirit of the present disclosure to those skilled in the art to which the present disclosure pertains. Accordingly, the present disclosure is not limited to the embodiments disclosed herein and can also be implemented in different forms. In the drawings, widths, lengths, thicknesses, and the like of devices can be exaggerated for clarity and descriptive purposes. When an element or layer is referred to as being "disposed above" or "disposed on" another element or layer, it can be directly "disposed above" or "disposed on" the other element or layer or intervening devices or layers can be present. Throughout the specification, like reference numerals denote like devices having the same or similar functions.

According to embodiments of the present disclosure, a lighting lamp module, that is, light emitting diode modules 1, 2, and 3 may be used for various types of lighting, and may be applied to, for example, a vehicular lighting lamp, more specifically, a head lamp. In addition, it may be applied to a head lamp to which Adaptive Driving Beam Application (ADB) technology is applied.

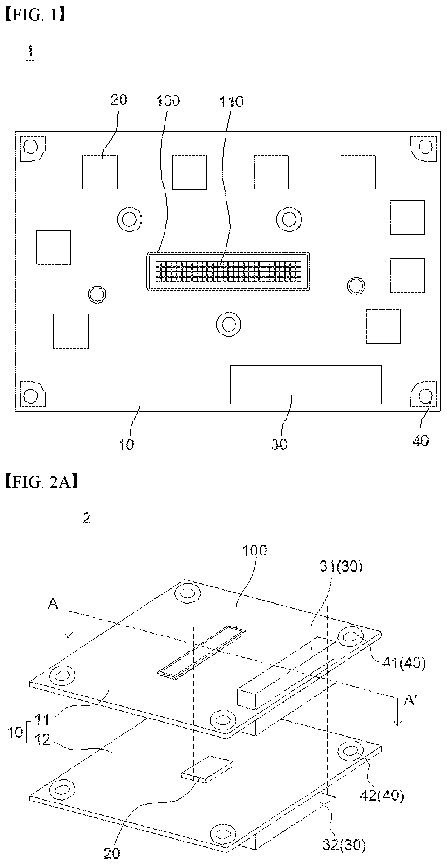

Referring to FIG. 1, according to a first embodiment of the present disclosure, the light emitting diode module 1 may include a light emitting diode package 100, and may be include a single layer, that is, a single printed circuit board (PCB) 10. For example, the PCB 10 may be a metal printed circuit board with favorable heat spread performance and favorable thermal conductivity. More specifically, the PCB may include Cu, Zn, Au, Ni, Al, Mg, Cd, Be, W, Mo, Si, and Fe, or an alloy of at least one of them as a base metal. However, the inventive concepts are not limited thereto, and various PCBs may be used depending on product characteristics.

A driving controller 20 for driving the light emitting diode package 100, for example, an integrated circuit (IC), may be disposed on the PCB 10. In addition, a connector 30 for receiving external power and electrically connecting elements on the PCB 10, a fixer 40 including a hole for securing an external apparatus and the light emitting diode module 1, and the like be mounted and assembled on the single PCB 10. In addition, according to the first embodiment, a size of the PCB 10 may be 1,500mm² to 4,000mm², or 4,000mm² or more, for example, 50mm x 30mm to 80mm x 65 mm.

According to an embodiment of the present disclosure, when applied to a headlight to which the Adaptive Driving Beam Application (ADB) technology is applied, the connector 30 may receive external power, and may further receive a signal from a front camera or laser signal. Alternatively, the connector 30 may receive a signal that can measure a distance to an object and image a shape of the object by installing a LiDAR and emitting a laser pulse to receive light reflected on a target object and returned.

Alternatively, the connector 30 may be a region including containing a conductive pattern for electrical connection.

In addition, the light emitting diode package 100 may include at least one or more light source units 110 generating and emitting light. For example, the light source unit 110 may be a plurality of light emitting diode cells, and the plurality of light emitting diode cells may form one light emitting diode chip. For example, 100 or more light emitting diode chips may be included, and at least one or more light emitting diode chips formed of 100 or more light emitting diode cells may be included. Through this, it is possible to implement an LED matrix beam capable of adjusting a lighting region.

Referring to FIG. 1, a plurality of light emitting diodes may be arrayed in rows and columns. The rows may be a single row, or a plurality of rows. The columns may be a single column as well, or may be a plurality of columns. The rows and columns may be adjusted depending on an area to emit light.

When this configuration of the light emitting diode package 100 is applied to the head lamp to which the ADB technology is applied, it is possible to implement smart lamp lighting. In other words, while keeping the head lamp turned on, by blocking only a portion of light that illuminates an opposite vehicle, an opposite driver's field of view may not be disturbed, thereby ensuring stability and reducing visual fatigue, especially during night driving. In addition, it may be usefully applied to night driving of autonomous vehicles in the future.

A more detailed configuration of the light emitting diode package 100 will be described later.

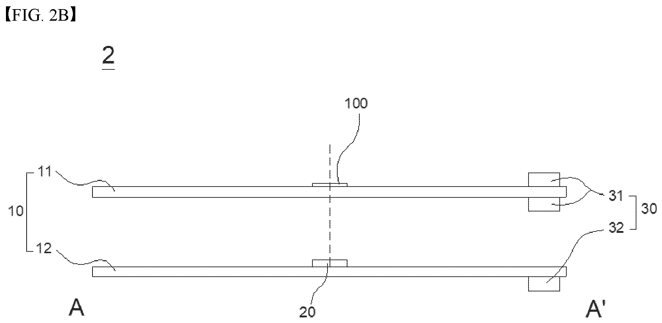

Referring to FIGs. 2A and 2B, according to a second embodiment of the present disclosure, a light emitting diode package 100 included in the light emitting diode module 2 and a driving controller 20 driving the light emitting diode package 100 may be separated from each other and mounted on a first PCB 11 and a second PCB 12, respectively. In other words, the light emitting diode module 2 may include a PCB 10 separated into two PCBs. For example, the second PCB 12 may be disposed under the first PCB 11. More specifically, in plan view, at least portions of the first PCB 11 and the second PCB 12 may be disposed to overlap with each other. In addition, the first PCB 11 and the second PCB 12 may be disposed at a predetermined vertical distance from each other, or the first PCB 11 may be disposed to overlap with at least one driving controller 20 disposed thereunder. For example, the first PCB 11 and the second PCB 12 may be spaced apart from each other at intervals of 1cm or more, without being limited thereto. Since the first PCB and the second PCB may be formed to be spaced apart to provide a path through which air can pass through a separation space, and heat generated in the light emitting package may be cooled by the air passing through a bottom of the first PCB, thereby improving a reliability of the light emitting device.

Areas of the first PCB 11 and the second PCB 12 may be smaller than that of the single-layer PCB 10 included in the light emitting diode module 1 of the first embodiment, for example, may be 1,000mm² to 4,000mm², and sizes of the first and second PCBs 11 and 12 may be 40mm × 32 mm, respectively.

In addition, the light emitting diode package 100 and a first connector 31 may be mounted on the first PCB 11, and the driving controller 20 and a second connector 32 may be mounted on the second PCB 12 disposed under the first PCB 11. For example, the first connector 31 may serve to receive external power to electrically connect the PCB 10 and the external device, or to electrically connect the first PCB 11 and the second PCB 12, and the second connector 32 may serve to electrically connect the first PCB 11 and the second PCB 12. In addition, according to an embodiment of the present disclosure, when applied to a head lamp to which the Adaptive Driving Beam Application (ADB) technology is applied, the connector 30 may receive external power and may further receive a signal from a front camera or laser signal. For example, the connector 30 may receive a signal that can measure a distance to an object and image a shape of the object by installing a LiDAR and emitting a laser pulse to receive light reflected on a target object and returned.

In addition, the light emitting diode package 100 disposed on the first PCB 11 and the driving controller 20 disposed on the second PCB 12 may vertically overlap with each other. In other words, in plan view of the PCB 10, at least portions of the light emitting diode package 100 and the driving controller 20 may overlap with each other. Alternatively, the first connector 31 and the second connector 32 may also vertically overlap with each other. In other words, in plan view, at least portions of the first connector 31 and the second connector 32 may overlap with each other.

The first connector 31 and the second connector 32 may be conductive materials for electrical connection.

The first PCB 11 or the second PCB 12 secures the external apparatus and the light emitting diode module 2, and may further include a fixer 40 including a hole for connecting and securing the PCB 11 and the second PCB 12 to each other. At least one or more fixers 40 may be disposed on the first PCB 11 and the second PCB 12, respectively, and may overlap vertically therewith. Although not shown in the drawings, a connection member connecting a first fixer 41 on the first PCB 11 and a second fixer 42 on the second PCB 12 may include, for example, a material having favorable thermal conductivity. In more detail, the first PCB 11 and the second PCB 12 may be secured with a metallic material having favorable thermal conductivity, without being necessarily limited thereto, and any material having hardness capable of supporting the first PCB and the second PCB is possible.

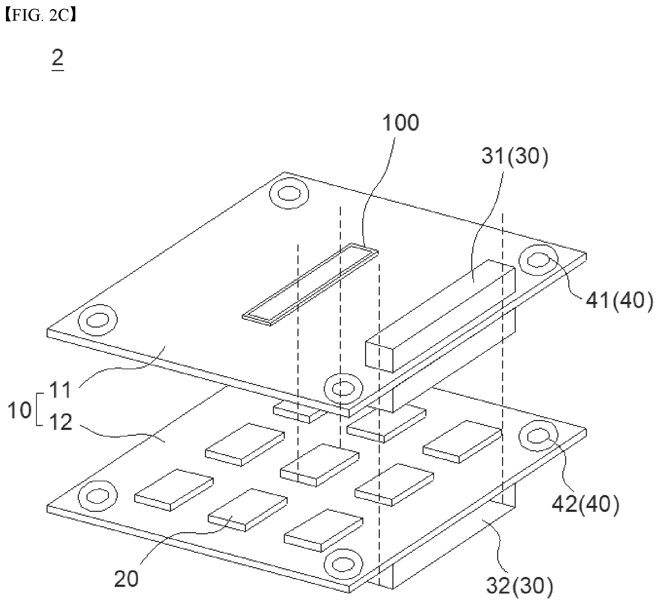

Referring to FIG. 2C, according to an exemplary embodiment of the present disclosure, a plurality of driving controllers 20 may be included depending on the number of light source units 110 mounted on the light emitting diode package 100. That is, the light emitting diode package 100 including a plurality of light source units 110 may be disposed on the first PCB 11, and the plurality of driving controllers 20 may be disposed on the second PCB 12. Since the number of light source units 110 that can be controlled by one driving controller 20 is limited, the number of driving controllers 20 has to be increased to perform a precise control of lighting of a light source as the number of light source units 110 increases. For example, when the number of light source units 110 mounted on the light emitting diode package 100 is 100 or more and the number of driving controllers 20 is 9 or more, each of the driving controllers 20 may control 11 or more light source units 110.

As the light emitting diode package 100 and the driving controller 20 are separated and disposed on two first and second PCBs 11 and 12, respectively, an area of the PCB 10 may be effectively reduced, compared to disposing the light emitting diode package 100 and the driving controller 20 together on one PCB 10. In particular, as the number of light source units 110 disposed in the light emitting diode package 100 increases, the number of driving controllers 20 also increases, so that an area required by the driving controllers 20 on the PCB 10 increases. Accordingly, when the light emitting diode package 100 and the driving controller 20 are separated and mounted on two PCBs 10, that is, the first PCB 11 and the second PCB 12, the area of the PCB 10 is effectively reduced, so that a lighting apparatus may be freely designed and disposed in a limited space. In addition, by vertically disposing a plurality of PCBs for effective heat spread as the area decreases, an air flow path may be formed between the plurality of PCBs to realize effective cooling.

According to an exemplary embodiment of the present disclosure, the number of light source units 110 mounted on the light emitting diode package 100 may be 100 or more, and the number of driving controllers 20 may be 9 or more. When the light emitting diode package 100 and the driving controllers 20 are mounted together on one PCB 10, a size of the PCB 10 may be, for example, 80mm × 65mm. However, when the light emitting diode package 100 and the driving controllers 20 of the light emitting unit are mounted on the first PCB 11 and the second PCB 12, respectively, each area of the first PCB 11 and the second PCB 12 may be, for example, 1,000mm² to 4,000mm², more specifically, 40mm × 32mm. In addition, the areas of the first PCB 11 and the second PCB 12 may be same or different.

As such, when the light emitting diode package 100 and the driving controller 20 are separately mounted on the two PCBs 10 that are the first PCB 11 and the second PCB 12, the size of the PCB 10 may be reduced to about 1/4 of that of mounting them together on one PCB 10. As the size of the PCB 10 is reduced, a size of the light emitting diode module 2 may be freely reduced, and as the size of the light emitting diode module 2 is reduced, a size of a peripheral apparatus mounting the light emitting diode module 2 may be reduced as well. Accordingly, a lighting apparatus including the light emitting diode module 2 may be freely designed even in a narrow space, without being restricted by area. For example, a vehicular headlamp has a sufficient inside space, but an area exposed to the outside is limited. By applying a miniaturized light emitting diode module to such a vehicular headlamp, it is possible to improve a performance of a light emitting device by providing effective heat spread while providing design freedom and flexibility in headlamp design, further in vehicle design.

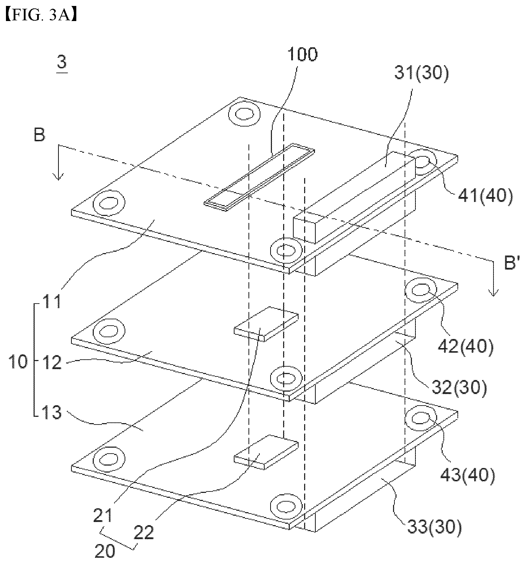

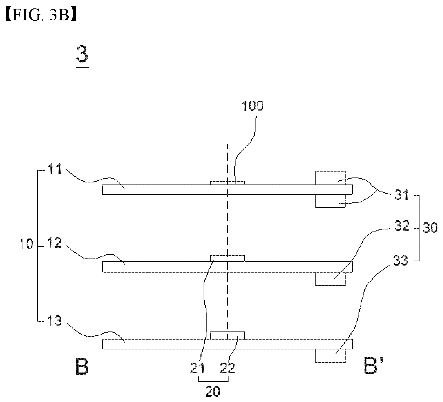

Referring to FIGs. 3A and 3B, according to a third embodiment of the present disclosure, the light emitting diode module 3 includes a first PCB 11 and a second PCB 12, and may further include a third PCB 13. For example, the second PCB 12 may be disposed under the first PCB 11, and the third PCB 13 may be disposed under the second PCB 12. In plan view, at least portions of the first PCB 11, the second PCB 12, and the third PCB 13 may overlap with one another. In addition, the first, second, and third PCBs 11, 12, and 13 may be disposed at a predetermined distance from one another. For example, the first, second, and third PCBs 11, 12, and 13 may be spaced apart from one another at intervals of 1cm or more, without being limited thereto. In addition, the distances at which the first, second, and third PCBs 11, 12, and 13 are spaced apart from one another may be same or different. Alternatively, the first PCB 11 may be disposed to overlap with at least one driving controller 21 disposed thereunder, and the second PCB 12 may be disposed to overlap with at least one driving controller 22 disposed thereunder.

In this case, an area of each of the first, second, and third PCBs 11, 12, and 13 may be smaller than that of one PCB 10 or that of each of the two PCBs 10. For example, the area of each of the first, second, and third PCBs 11, 12, and 13 may be less than 1,000mm².

In addition, the light emitting diode package 100, a plurality of controllers 20, and a plurality of connectors 30 may be separately mounted on the first, second, and third PCBs 11, 12, and 13, respectively. For example, the light emitting diode package 100 and a first connector 31 may be disposed on the first PCB 11, and a first driving controller 21 and a second connector 32 may be disposed on the second PCB 12. In addition, a second driving controller 22 and a third connector 33 may be disposed on the third PCB 13. For example, the first connector 31 may serve to electrically connect an external apparatus and the PCB 10 by receiving external power, and the second connector 32 may serve to electrically connect the first PCB 11 and the second PCB 12. In addition, the third connector 33 may serve to electrically connect the second PCB 12 and the third PCB 13.

In addition, the light emitting diode package 100 and the first and second driving controllers 20 may vertically overlap. In other words, in plan view of the PCB 10, at least portions of the light emitting diode package 100 and the first driving controller 21 may overlap with each other, or at least portions of the light emitting diode package 100 and the second driving controller 22 may overlap with each other. Alternatively, at least portions of the first driving controller 21 and the second driving controller 22 may overlap with each other. In addition, the first, second, and third connectors 30 may also vertically overlap. In plan view, at least portions of the first connector 31 and the second connector 32 may overlap with each other, or at least portions of the second connector 32 and the third connector 33 may overlap with each other. Alternatively, at least portions of the first connector 31 and the third connector 33 may overlap with each other.

The first connector 31, the second connector 32, and the third connector 33 may be conductive materials for electrical connection.

In addition, a fixer 40 including a hole for securing the external apparatus and the light emitting diode module 3 and connecting the first, second, and third PCBs 10 to one another to secure them may be further included. At least one or more fixers 40 may be provided, disposed on each of the first, second, and third PCBs 11, 12, and 13, and may be overlapped vertically therewith. Although not shown in the drawings, a connection member connecting a first fixer 41 on the first PCB 11, a second fixer 42 on the second PCB 12, and a third fixer 43 on the third PCB 13 may include, for example, a material having favorable thermal conductivity. In more detail, the first PCB 11, the second PCB 12, and the third PCB 13 may be connected and secured with a metallic material having favorable thermal conductivity, without being necessarily limited thereto, and any material having hardness capable of supporting the first PCB and the second PCB is possible.

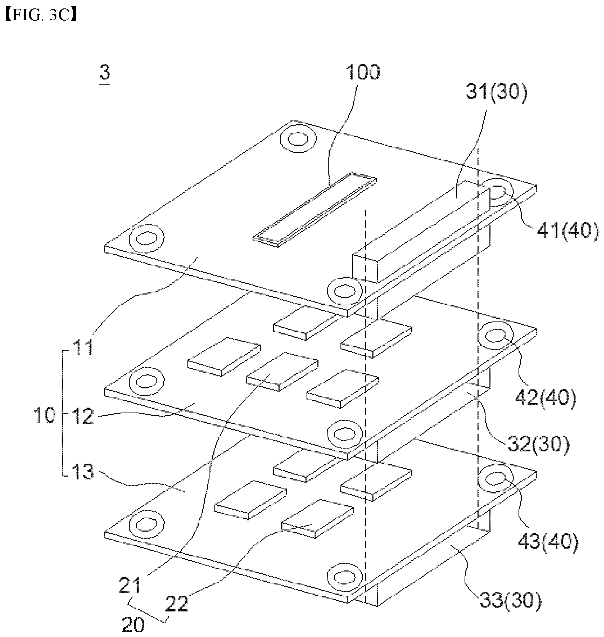

Referring to FIG. 3C, depending on the number of light source units 110 mounted on the light emitting diode package 100, a plurality of driving controllers 20 may be included, and the plurality of driving controllers 20 may be separately disposed on the second PCB 12 and the third PCB 13, respectively. That is, the light emitting diode package 100 including a plurality of light source units 110 may be disposed on the first PCB 11, and at least one or more first driving controllers 21 may be disposed on the second PCB 12. In addition, at least one or more second driving controllers 22 may be disposed on the third PCB 13 as well.

The driving controller 21 disposed on the second PCB 12 and the driving controller 20 disposed on the third PCB 13 may include a plurality of driving controllers of different numbers from each other.

By separating the light emitting diode package 100 and the driving controllers 21 and 22 and disposing them on separate PCBs 10, and further separating the driving controllers 20 and disposing them on separate PCBs 10, that is, by disposing them separately on the first, second, and third PCBs 10, an area of the PCB 10 may be effectively reduced compared to disposing the light emitting diode package 100 and the first and second driving controllers 21 and 22 together on one PCB 10. In particular, as the number of light source units 110 disposed in the light emitting diode package 100 increases, the number of driving controllers 20 increases as well. Accordingly, an area occupied by the driving controllers 20 on the PCB 10 is further increased. Accordingly, by disposing the light emitting diode package 100 and the driving controllers 20 separately, and by further separating the driving controllers 20 into the first and second driving controllers 21 and 22 to dispose them on three PCBs 10, that is, to dispose them on the first PCB 11, the second PCB 12, and the third PCB 13, the area of the PCB 10 may be effectively reduced. Accordingly, a size of the light emitting diode module 3 may be reduced to provide the light emitting diode module 3 that can be efficiently disposed even in a narrow space.

According to an exemplary embodiment of the present disclosure, when the light emitting diode package 100 and the driving controllers 20 are separately mounted on two PCBs 10, an area of each of the first PCB 11 and the second PCB 12 may be, for example, 1,000mm² to 4,000mm². More specifically, it may be 40mm × 32mm. In a case that the same number of the light emitting packages 100 and the driving controllers 20 as that described above are disposed separately on the light emitting diode module 3 that has three PCBs 10 , that is, the first, second, and third PCBs 11, 12, and 13, an area of the first, second, and third PCBs 11, 12, and 13 may be reduced compared to the light emitting diode module 2 to which two PCBs 10 are applied, thereby minimizing the area of the PCB 10.

As such, as the size of the PCB 10 is reduced by minimizing the area of the PCB 10 in this way, the size of the light emitting diode module 3 may be freely reduced, and as the size of the light emitting diode module 3 decreases, a size of a peripheral apparatus mounting the light emitting diode module 3 may be reduced as well. Accordingly, a lighting apparatus including the light emitting diode module 3 may be freely designed even in a narrow space, without being restricted by space. For example, a vehicular head lamp has a sufficient mounting space inside, but an area exposed to the outside is limited. By applying a miniaturized light emitting diode module to such a vehicular head lamp, it is possible to provide design freedom and flexibility in head lamp design, further in vehicle design.

In addition, depending on a space of an apparatus to which the light emitting diode module is applied, the number of PCBs 10 that can be disposed may be further increased to further separately dispose driving controllers 20. As the number of PCBs 10 further increases, the size of the light emitting diode module may be miniaturized by effectively reducing the area of PCBs 10, so that a product on which the light emitting diode module is mounted may be designed without being restricted by space, and thus, it is possible to effectively dissipate heat while having design freedom and flexibility, thereby improving a performance of a light emitting device.

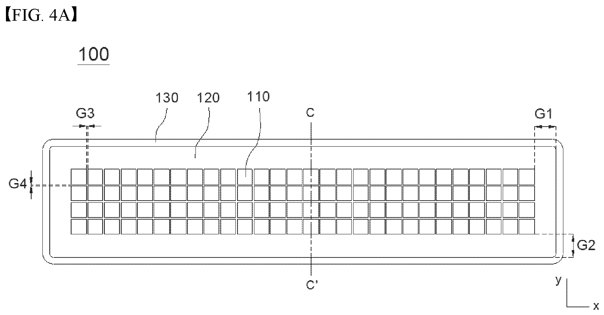

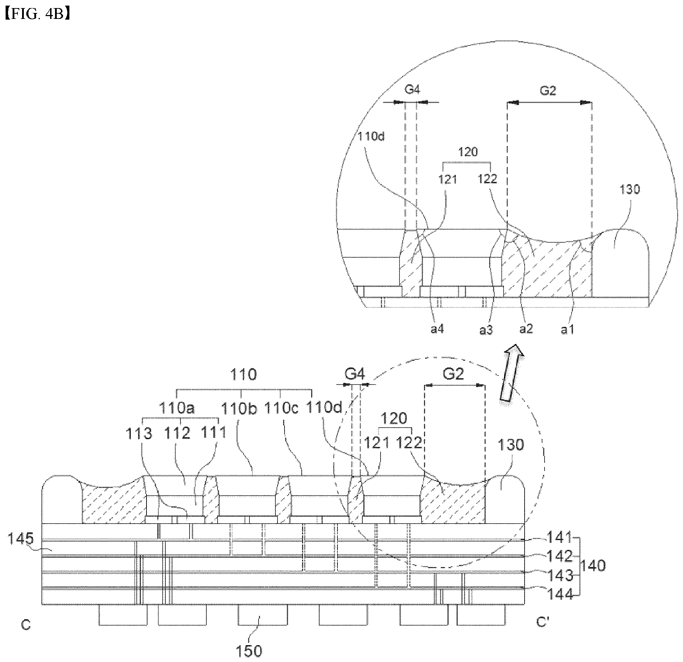

FIGs. 4A and 4B are diagrams illustrating a light emitting diode package 100 mounted on light emitting diode modules 1, 2, and 3 according to an embodiment of the present disclosure, and FIG. 4B is a view illustrating cross section C-C' of FIG. 4A. The light emitting diode package 100 may include one or more light emitting units 110. In addition, a light control layer 120 surrounding the light emitting unit 110 and a first dam portion 130 surrounding the light emitting unit 110 and the light control layer 120 may be further included. A height of the first dam portion 130 may be similar to that of the light emitting unit 110, and a difference in height between the first dam portion 130 and the light emitting unit 110 may be within 20% based on a higher thickness of the two. For example, the height of the first dam portion 130 may be higher, or may be lower than that of the light emitting unit 110. Alternatively, they may have a same height.

In addition, the light emitting unit 110 and the first dam portion 130 may be spaced apart by G1 in an x-axis direction, and spaced apart by G2 in a y-axis direction. In addition, the light control layer 120 may fill a space between the spaced intervals G1 and G2, that is, a space between the light emitting unit 110 and the first dam portion 130. The light control layer 120 may be a reflection material having reflection characteristics. In addition, it may be a material capable of blocking unnecessary light and protecting a light emitting diode device. In other words, the light control layer 120 may be a material capable of reflecting light emitted from a side surface of the light source unit 110. Light reflected by the light control layer 120 may be directed to an upper surface of the light source unit 110. Accordingly, the light control layer prevents light emitted from the side surface of the light source unit 110 from not being extracted to the upper surface, and guides light to be extracted to the upper surface, thereby increasing an amount of light.

The light control layer 120 may be, for example, a material including silicone resin, and more specifically, may be white silicone. However, the inventive concepts are not limited thereto, it may be black silicone, and a color of silicone may be various. In addition, the first dam portion 130 for preventing the light control layer 120 from overflowing may also be a material including a silicone resin like the light control layer 120, but silicone contents may be different from each other. In addition, a color of the first dam portion 130 may also be formed in various colors such as white, black, or others.

In addition, a plurality of light emitting units 110 may be disposed, for example, more light source units 110 may be disposed in the x-axis direction than in the y-axis direction. In addition, the number of light source units 110 disposed in rows may be different from the number of light source units 110 disposed in at least one column. More specifically, 20 or more columns of light emitting units 110 or 20 or more light emitting units 110 may be disposed in the x-axis direction, and 1 or more rows of light emitting units 110 or 4 or more of light emitting units 110 may be disposed in the y-axis direction. In other words, 28 light emitting units 110 may be disposed in each of 4 rows, and 4 light emitting units 110 may be disposed in each of 28 columns, so that a total of 112 light emitting units 110 may be disposed in the light emitting diode package 100.

As such, when the plurality of light emitting units 110 is disposed, referring to FIG. 4B, first light control layers 122 may be included between a first light emitting unit 110a and the first dam portion 130 and between a fourth light emitting unit 110d and the first dam portion 130. In addition, second light control layers 121 may be further included between the first light emitting unit 110a and a second light emitting unit 110b, between the second light emitting unit 110b and a third light emitting unit 110c, and between the third light emitting unit 110c and the fourth light emitting unit 110d.

The first light control layer 121 and the second light control layer 122 may be formed of a same material or different materials. In other words, light may be well extracted to the upper surface of the light source unit 110 by reflecting light emitted from the side surface of the light source unit 110, and any material capable of protecting the light emitting unit 110 is possible. The first light control layer may have a shape in which a width thereof becomes narrower toward an upper portion. Alternatively, at least portions of side surfaces of the first light control layer may include an inclined surface, and may include a plurality of surfaces having different inclinations.

In addition, according to an exemplary embodiment of the present disclosure, the height of the light emitting unit 110 and the height of the first dam portion 130 may be the same, without being limited thereto, but may have different heights from each other. When the light control layer 120 is filled in the space between the light emitting unit 110 and the first dam portion 130, depending on the heights of the light emitting unit 110 and the first dam portion 130 and material characteristics of the light control layer 120, a shape in which the light control layer 120 is filled may be various. For example, a middle portion of the light control layer 120 may be concave, or may be flat or convex. In addition, the light emitting unit 110 and the light control layer 120 may form a predetermined angle a2, and the first dam portion 130 and the light control layer 120 may also form a predetermined angle a1. The predetermined angles a1 and a2 may vary depending on the heights of the light emitting unit 110 and the first dam portion 130, and may be formed, for example, smaller than 180 degrees, or substantially smaller than 90 degrees. An upper surface of the second light control layer may have a curved shape.

In addition, the light emitting unit 110 may be disposed over a support member 145, and a lower electrode 150 may be disposed under the support member 145. The support member 145 may include an interconnection portion 140 to electrically connect the light emitting unit 110 and the support member 145. In addition, the light emitting unit 110 may include a light emitting portion 111, a light transmitting portion 112, and an electrode pad 113. The electrode pad 113 may include a P electrode and an N electrode, and may be electrically connected to the lower electrode 150. In addition, a plurality of interconnection portions 140 may also be disposed to electrically connect the plurality of light emitting units 110 to the lower electrode 150. For example, as the first through fourth light emitting units 110a, 110b, 110c, and 110d are disposed, first through fourth interconnection portions 141, 142, 143, and 144 may connect each of the light emitting units 110.

In addition, the light transmitting portion 112 disposed over the light emitting portion 111 of the light emitting unit 110 may further include a material that can transmit light, for example, a wavelength conversion material, more specifically, the light transmitting portion 112 may be a light-transmitting material so that light generated in the light emitting portion 111 is emitted upward, and a wavelength region of light may be converted inside the light transmitting portion 112 to emit light.

In other words, the light transmitting portion 112 may resin, glass, or the like formed of a material through which light is transmitted, and may include a light characteristic conversion material dispersed therein. The light characteristic conversion material may be any material capable of converting a wavelength range of light. For example, the light characteristic conversion material may be formed of at least one of a phosphor and a quantum dot. In addition, phosphors of various structures may be dispersed, and the structures of phosphors may vary depending on types of phosphors. In addition, the light transmitting portion 112 may be possible in a sheet form or a resin form.

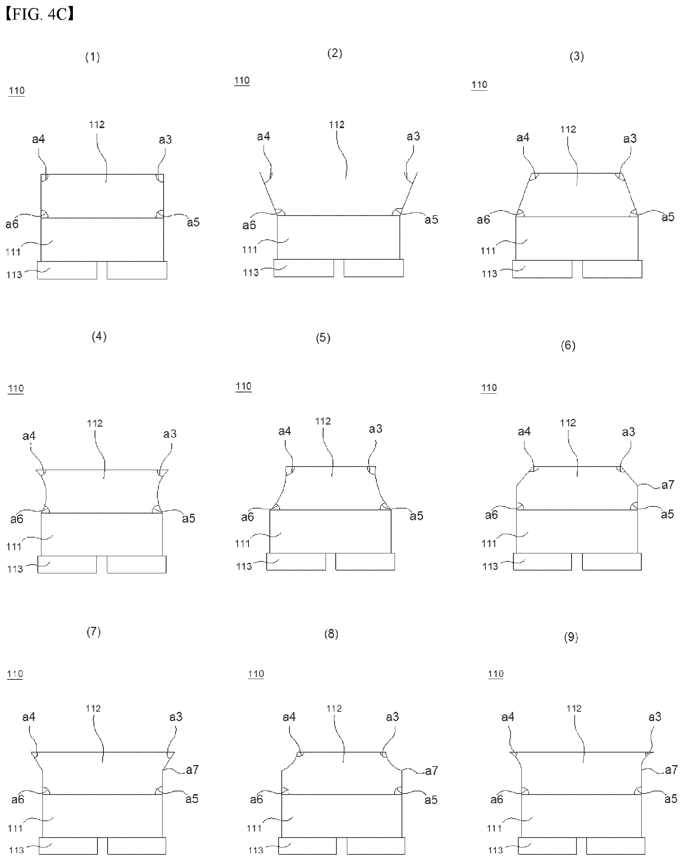

FIG. 4C is a diagram illustrating various shapes of the light transmitting portion 112 disposed over the light emitting portion 111 according to an exemplary embodiment of the present disclosure. Referring to (1) ofFIG. 4C, at least a portion of the light transmitting portion 112 may include a predetermined angle. For example, predetermined angles a3 and a4 disposed at an upper portion of the light transmitting portion 112 and predetermined angles a5 and a6 disposed at a lower portion of the light transmitting portion 112 adjacent to the light emitting portion 111 may be same. In addition, at least one or more of the predetermined angles a3, a4, a5, and a6 may be about 90 degrees, and the light transmitting portion 112 may be formed in a rectangular shape.

Referring to (2) of FIG. 4C, predetermined angles a3, a4, a5, and a6 disposed at partial regions of the light transmitting portion 112 may be different from one another. For example, the predetermined angles a5 and a6 disposed at a lower portion of the light transmitting portion 112 may be greater than the predetermined angles a3 and a4 disposed at an upper portion of the light transmitting portion 112, and a side surface of the light transmitting portion 112 connecting the upper portion and the lower portion of the light transmitting portion 112 may include a surface at least partially inclined. In addition, a width of the upper portion of the light transmitting portion 112 may be wider than a width of the lower portion of the light transmitting portion 112, and the width of the light transmitting portion 112 may gradually widen from the lower portion to the upper portion of the light transmitting portion 112.

Referring to (3) of FIG. 4C, predetermined angles a5 and a6 disposed at a lower portion of the light transmitting portion 112 may be smaller than predetermined angles a3 and a4 disposed at an upper portion of the light transmitting portion 112. In this case, a side surface of the light transmitting portion 112 connecting the upper portion and the lower portion of the light transmitting portion 112 may include a surface at least partially inclined. In addition, a width of the upper portion of the light transmitting portion 112 may be narrower than a width of the lower portion of the light transmitting portion 112, and the width of the light transmitting portion 112 may gradually narrow from the lower portion to the upper portion of the light transmitting portion 112.

Referring to (4) of FIG. 4C, an upper width of the light transmitting portion 112 may be wider than a lower width of the light transmitting portion 112. In addition, a curved surface may be included in at least a portion of a side surface of the light transmitting portion 112. In this case, the width of the light transmitting portion 112 may narrow from a lower portion to an upper portion and then widen again. Depending on an inclination of the curved surface, predetermined angles a3 and a4 disposed at the upper portion of the light transmitting portion 112 and predetermined angles a5 and a6 disposed at the lower portion of the light transmitting portion 112 may be formed in various ways.

Referring to (5) ofFIG. 4C, an upper width of the light transmitting portion 112 may be narrower than a lower width of the light transmitting portion 112. In addition, at least a portion of a side surface of the light transmitting portion 112 may include a curved surface, and the width of the light transmitting portion 112 may narrow from a lower portion to an upper portion and then widen again. Depending on an inclination of the curved surface, predetermined angles a3 and a4 disposed at the upper portion of the light transmitting portion 112 and predetermined angles a5 and a6 disposed at the lower portion thereof may be formed in various ways.

Referring to (6) and (7) of FIG. 4C, at least one or more inflection points a7 at which an inclination thereof changes may be included in a partial region of one surface of the light transmitting portion 112. For example, the partial region of one surface of the light transmitting portion 112 may include a straight line, and a straight line having an inclination different from that of the straight line may be included in another partial region of the one surface, with respect to the inflection point a7.

In addition, referring to (8) and (9) ofFIG. 4C, a curved line may be included in another partial region of the one surface with respect to the inflection point a7. In this case, the curved line may be a concave surface in an inner direction of the light transmitting portion 112, or may be a convex surface.

As such, by including various shapes in which the inclinations thereof change on at least one or more surfaces of the light transmitting portion 112, when light generated in the light emitting portion 111 is directed to the one surface of the light transmitting portion 112, light may be reflected and emitted upward to the light transmitting portion 112, thereby increasing a light extraction efficiency.

In addition, at least a portion of the light transmitting portion 112 may include predetermined angles a3 and a4. For example, the predetermined angles a3 and a4 may be less than 90 degrees, but the inventive concepts are not limited thereto. Due to the predetermined angles a3 and a4, the side surface of the light transmitting portion 112 may include an inclined surface, so that light emitted to the side surface of the light transmitting portion 112 may be guided to be reflected and emitted toward the upper surface, thereby increasing the light extraction efficiency.

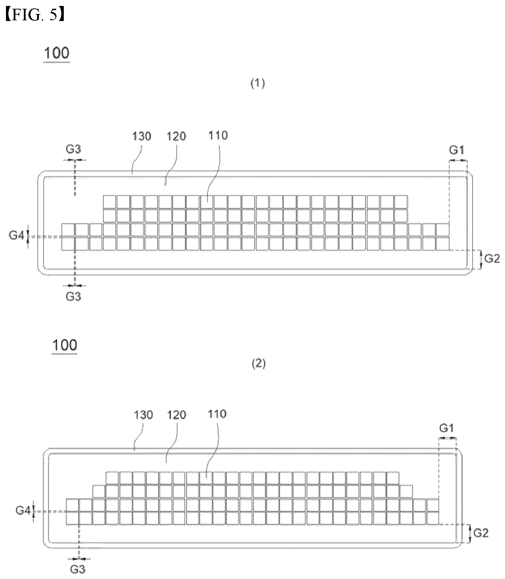

Referring to FIG. 5, in plan view of a light emitting diode package 100, a plurality of light emitting units 110 may be disposed in various shapes. In other words, the plurality of light emitting units 110 may be disposed in plurality in each of rows and columns to implement a matrix beam. By implementing such a matrix beam, the light emitting units 110 may be individually controlled, so that the light emitting units 110 may be driven independently, thereby selectively and precisely controlling a light irradiation range. For example, ADB technology may be applied to vehicular head lamps to block light only in local regions, such as vehicles ahead, and not to block light in other regions for driving safety.

Referring to (1) of FIG. 5, for example, the light emitting units 110 may not be disposed in columns 1 through 3 of rows 1 and 2 among 4 rows and 28 columns, and the light emitting unit 110 may not be disposed even in columns 26 through 28 of rows 1 and 2. Accordingly, in a matrix form, 6 light emitting units 110 may not be disposed on an upper right portion and an upper left portion, respectively, and a total of 100 light emitting units 110 may be disposed to implement the matrix beam.

In addition, in the matrix form, right and left sides may have a symmetrical form with respect to a virtual line of a center.

Referring to (2) of FIG. 5, for example, the light emitting units 110 may not be disposed in columns 1 through 3 of row 1 among 4 rows and 28 columns, and the light emitting units 110 may not be disposed in columns 1 and 2 of row 2. In addition, the light emitting units 110 may not be disposed in columns 26 through 28 of row 1, and the light emitting units 110 may not be disposed in columns 27 and 28 of row 2. Accordingly, the light emitting units 110 may be disposed in a matrix form such that the upper right portion and the upper left portion have a stepped shape. Since five light emitting units 110 may not be disposed on each of the right and left upper portions, a total of 102 light emitting units 110 may be disposed to implement the matrix beam.

However, a shape in which the plurality of light emitting units 110 is disposed and the number of the light emitting units 110 are not limited thereto, and they may vary depending on a target to be irradiated with light emitted from the light emitting diode package 100.

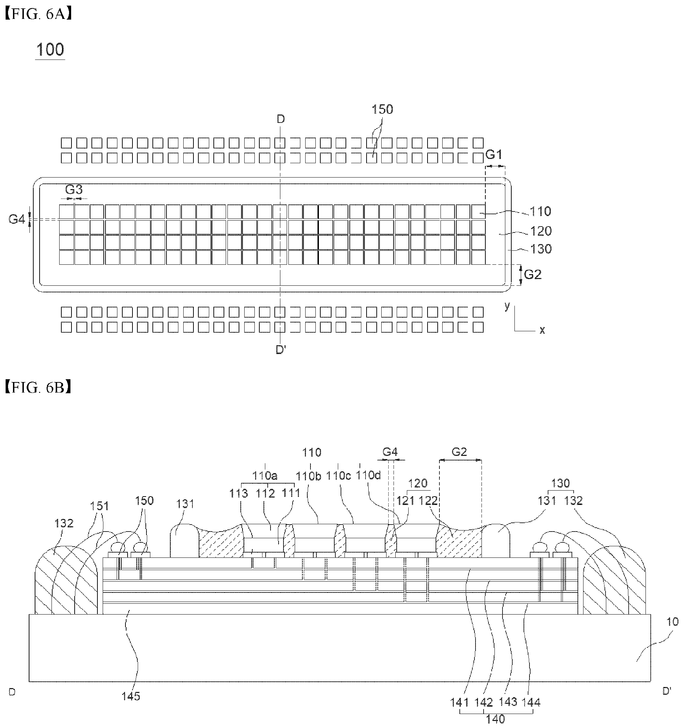

Referring to FIG. 6A, it is a view illustrating a light emitting package including a wire contact electrode 150 for wire bonding to electrically connect a light emitting unit 110 and a PCB 10 according to an exemplary embodiment of the present disclosure. FIG. 6A shows an upper surface of a light emitting diode package 100 before wires are connected, and FIGs. 6B through 6E show various embodiments in a state where wires are connected.

FIG. 6B is a cross-sectional view showing a D-D' cross section of FIG. 6A in a state where the contact electrode 150 and the PCB 10 are connected by a wire 151. The PCB 10 and the light emitting unit 110 may be electrically connected through the wire 151, and the contact electrode 150 of the wire 151 and each of the light emitting units 110 may be electrically connected through an interconnection portion 140. In addition, the number of the interconnection portions 140 varies depending on the number of light emitting units 110, and for example, first through fourth interconnection portions 141, 142, 143, and 144 may be disposed to electrically connect first through fourth light emitting units 110a, 110b, 110c, and 110d.

In addition, to protect the wire 151 connected to an upper portion of the PCB 10, a second dam portion 132 may be further disposed in a partial region of the wire 151, that is, in a partial region of the wire 151 in the upper portion of the upper portion of the PCB 100. The second dam portion 132 may be formed to cover a portion of the wire 151 exposed in the upper portion of the PCB 10, and for example, it may be formed to be higher or lower than a height of a support member 145, or to be at a same height as that of the support member 145. In addition, it may be a material including a silicone resin, or may be a same material as that of a first dam portion 131. However, the inventive concepts are not limited thereto, and any material capable of improving reliability and characteristics of a product through protecting the wire 151 is possible.

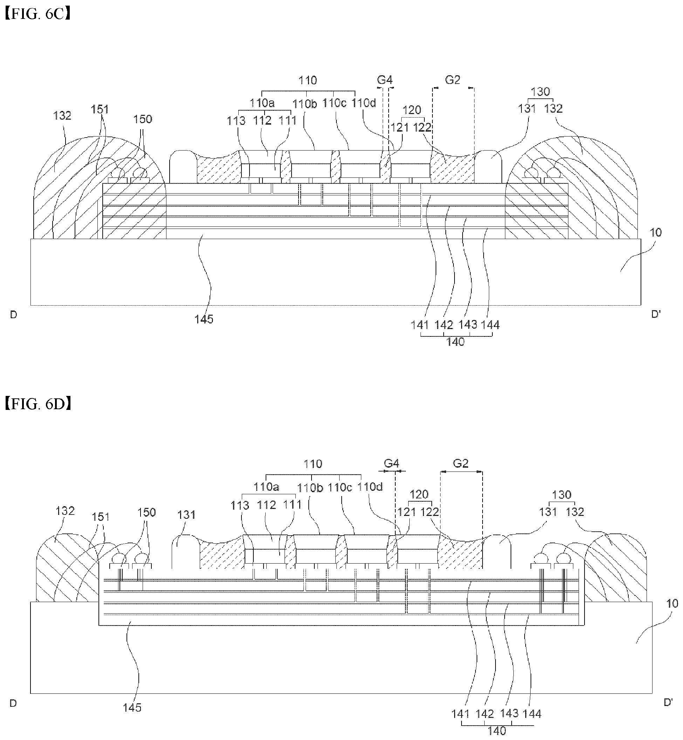

Referring to FIG. 6C, according to an exemplary embodiment of the present disclosure, the second dam portion 132 may be formed to cover an entire upper portion of the wire 151 bonded to the PCB 10 and the contact electrode 150. In this case, the height of the second dam portion 132 may be higher than that of the first dam portion 131. In addition, since the upper portion where the wire 151 and the contact electrode 150 are connected can be protected, the second dam portion 132 may secure an entire wire 151. Accordingly, the wire 151 may be more stably secured to the light emitting diode package 100, and thus, a defect rate may be reduced, thereby further increasing the product reliability.

Referring to FIG. 6D, according to an exemplary embodiment of the present disclosure, at least a portion of the support member 145 on the PCB 10 may be embedded in a portion of the PCB 10. The second dam portion 132 may cover a partial region of the wire 151 on the PCB 10 to protect the wire 151. In addition, as the portion of the support member 145 is embedded in the PCB 10, the height of the second dam portion 132 may be higher than that of the contact electrode 150, or may be higher than that of the wire 151. In addition, although not shown in the drawings, the second dam portion 132 may cover the entire wire 151. In this case, a degree of upward protrusion of the second dam portion 132 may be lower than that of FIG. 6C.

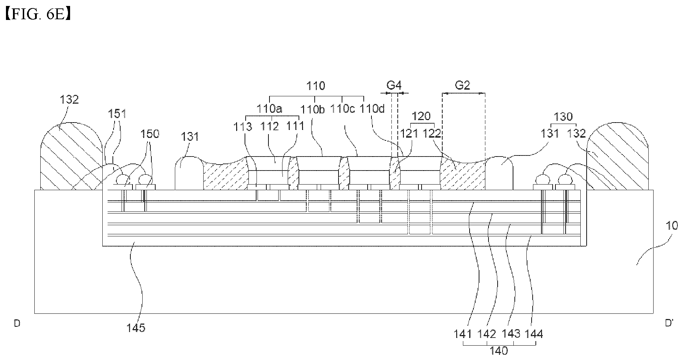

Referring to FIG. 6E, according to an exemplary embodiment of the present disclosure, an entire support member 145 on the PCB 10 may be embedded in a portion of the PCB 10. Accordingly, a height of the PCB 10 and a height of the support member 145 in a region where the second dam portion 132 is disposed may be same, or the height of the support member 145 may be lower. The second dam portion 132 may be disposed to cover the upper portion of the wire 151 on the PCB 10, and in this case, an amount of the second dam portion 132 of FIG. 6E may be smaller than those of the second dam portions 132 of FIGs. 6B through 6D, and the height of the second dam portion 132 may be lower. In addition, although not shown in the drawings, the second dam portion 132 may cover the entire wire 151. The second dam portions 132 of FIGs. 6B through 6E protect the wire 151, and thus, the wire 151 may be stably secured to the light emitting diode package 100, thereby reducing the defect rate of a product and improving characteristics of the product.

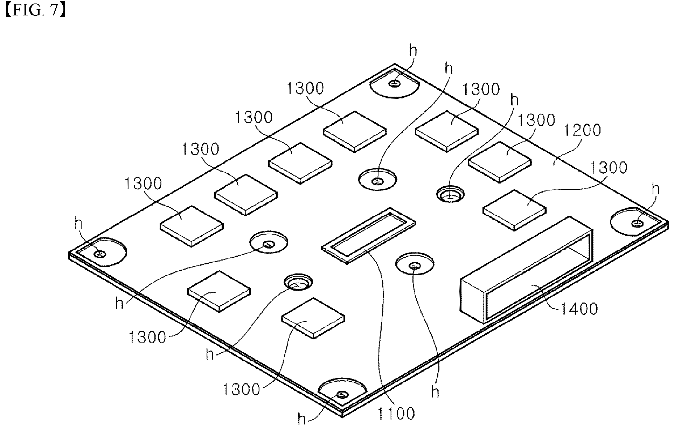

FIG. 7 is a view of a light emitting diode module according to a fourth embodiment of the present disclosure.

Referring to FIG. 7, the light emitting diode module according to the fourth embodiment of the present disclosure includes a printed circuit board 1200, a light emitting diode package 1100 disposed in a central portion of the printed circuit board 1200, a plurality of driving chips 1300 disposed on the printed circuit board 1200 to surround the light emitting diode package 1100, a connector 1400 disposed on an edge side of the printed circuit board 1200, and a plurality of holes h formed in the printed circuit board 1200.

In general, the driving chip 1300 is optimized to drive about 12 to 13 light emitting diode chips, and when the light emitting diode package 1100 includes, for example, 112 light emitting diode chips, at least 15 driving chips 1300 are required to drive all light emitting diode chips. However, due to heat generation of the light emitting diode package 1100, the light emitting diode package 1100 and the driving chip 1300 cannot be disposed closer than a certain distance.

In a case of driving a large number of light emitting diode chips as described above, a plurality of driving chips 1300 should be disposed accordingly, the light emitting diode package 1100 and the plurality of driving chips 1300 are separated by a certain distance or more due to heat generation, and the connector 1400, a resistor, a capacitor, and others need to be disposed together as well, and thus, it is almost impossible with current technology to reduce the printed circuit board 1200 to a certain size or less.

When the size of the printed circuit board 1200 increases, a size of peripheral components also increases proportionally, and a design thereof is restricted.

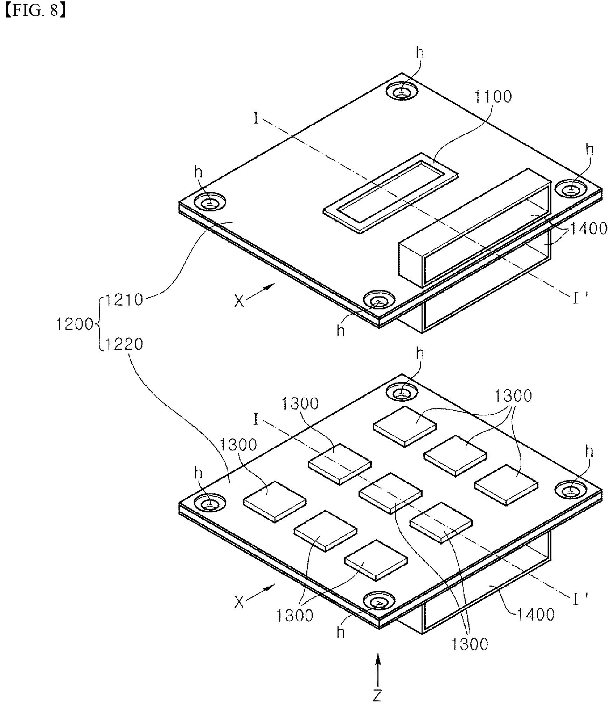

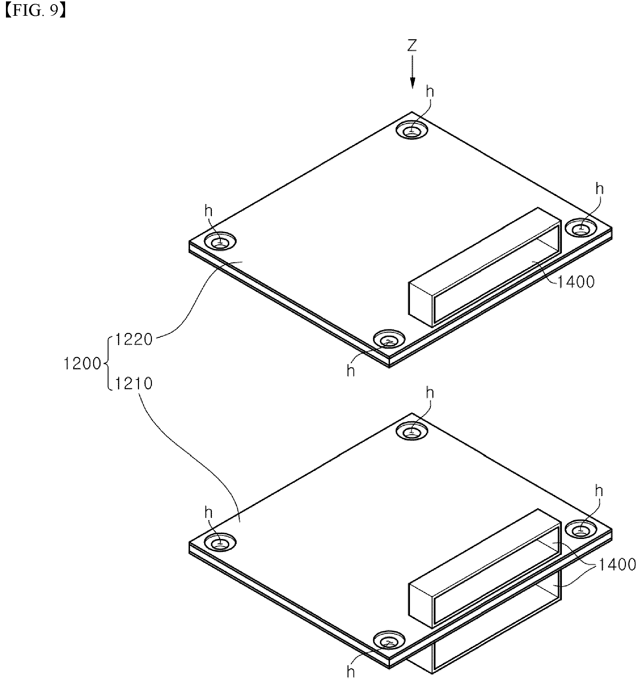

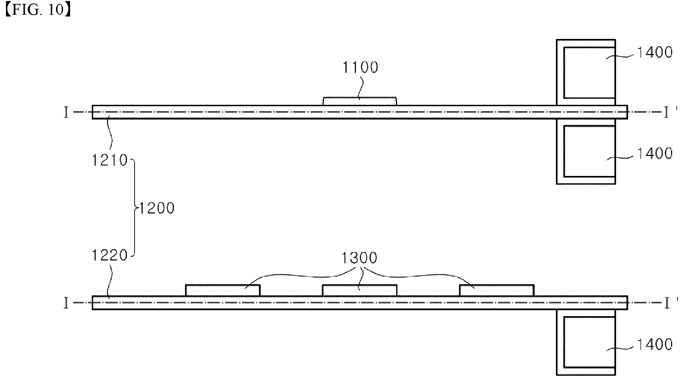

FIG. 8 is a view of a light emitting diode module according to a fifth embodiment of the present disclosure, FIG. 9 is a view of the light emitting diode module shown in FIG. 8 viewed from a bottom (Z direction), and FIG. 10 is a view of a cross section (I-I' direction) of the light emitting diode module shown in FIG. 8 viewed from an X direction.

Referring to FIGs. 8 through 10, the light emitting diode module according to the fifth embodiment of the present disclosure includes a printed circuit board 1200, a light emitting diode package 1100, a connector 1400, and a driving chip 1300.

The printed circuit board 1200 of the present disclosure is formed in plurality, and includes two printed circuit boards 1210 and 1220 in this embodiment. The printed circuit board 1200 is preferably made of a metallic material.

The light emitting diode package 1100 is disposed on a first printed circuit board 1210 in an upper portion (in the drawing, it is disposed in the upper portion, but when applied to a headlamp, it is disposed in a front side. Hereinafter, the same) and preferably, the light emitting diode package 1100 is disposed in a central portion of the first printed circuit board 1210.

The connector 1400 is disposed on one edge of the first printed circuit board 1210. The connector 1400 may be disposed on a same side as the light emitting diode package 1100, disposed on an opposite side, or may be disposed on both sides of the first printed circuit board 1210 as shown in FIGs. 8 through 10. In addition, when the connectors 1400 are disposed on both sides of the first printed circuit board 1210, it is preferable that the connectors 1400 on each side are disposed at positions opposite to each other. The connector 1400 may be a conductive material for electrical connection.

A plurality of holes h passing through the first printed circuit board 1210 is formed in the first printed circuit board 1210, and preferably, the plurality of holes h is formed near corners of the first printed circuit board 1210, respectively.

The driving chip 1300 is disposed on a second printed circuit board 1220 in a lower portion (in the drawing, it is disposed in the lower portion, but when applied to a headlamp, it is disposed in a rear side. Hereinafter the same). When 9 driving chips 1300 are required to drive the light emitting diode package 1100, all 9 driving chips are disposed on the second printed circuit board 1220. Although FIG. 8 shows that 9 driving chips are arranged in a 3 × 3 array, the inventive concepts are not limited thereto.

The connector 1400 is disposed on one edge of the second printed circuit board 1220. The connector 1400 may be disposed on a same side as the driving chip 1300, may be disposed on an opposite side, or may be disposed on both sides of the second printed circuit board 1220. FIGs. 8 through 10 show that the connector 1400 is disposed on the opposite side of the driving chip 1300. In particular, when there are many driving chips 1300 to be disposed on the second printed circuit board 1220, it is advantageous to dispose the connector 1400 on the opposite side of the driving chip 1300 in reducing a size of the second printed circuit board 1220.

In addition, it is preferable that the connector 1400 of the first printed circuit board 1210 and the connector 1400 of the second printed circuit board 1220 are disposed in a same direction to efficiently connect cables or others.

By connecting the connector 1400 of the first printed circuit board 1210 and the connector 1400 of the second printed circuit board 1220 with a cable or the like, the light emitting diode package 1100 of the first printed circuit board 1210 may be driven by the driving chip 1300 of the second printed circuit board 1220. The connector 1400 serves as a passage for receiving signals, power, and the like according to a distance to a vehicle or pedestrian in front measured by a camera.

A plurality of holes h passing through the second printed circuit board 1220 is formed in the second printed circuit board 1220, and preferably, the plurality of holes h is formed near corners of the second printed circuit board 1220, respectively.

The hole h formed in the first printed circuit board 1210 and the hole h formed in the second printed circuit board 1220 are penetrated by a bolt or the like, and the first and second printed circuit boards 1210 and 1220 are secured in a state that they are spaced apart. Although it is not necessary to use the bolt to secure the first and second printed circuit boards 1210 and 1220, it is preferable to secure them using a material that is favorable to heat spread.

A distance between the printed circuit boards 1210 and 1220 may be adjusted by adjusting a length of the bolt or the like between the printed circuit boards 1210 and 1220. Considering heat spread, the distance between the first and second printed circuit boards 1210 and 1220 is preferably 3mm to 20mm.

In addition, by adjusting positions of the hole h formed in the first printed circuit board 1210 and the hole h formed in the second printed circuit board 1220, arrangements of the first and second printed circuit boards 1210 and 1220 may be adjusted. For example, the first printed circuit board 1210 and the second printed circuit board 1220 may be arranged such that edges thereof are flush with each other vertically over and under (front and rear when applied to a headlamp), but may be arranged such that edges thereof are in an oblique line and only a partial area overlaps, or they may be arranged such that there is no overlapping area at all if there is space. In a case where the first and second printed circuit boards 1210 and 1220 are arranged such that portions or all of them do not overlap, it is more favorable to dissipate generated heat compared to a case where their edges are arranged in flush.

In addition, the light emitting diode module of this embodiment may be disposed in contact with a heat sink of the headlamp. That is, by forming holes through which a portion of a structure of the heat sink can pass in the first and second printed circuit boards 1210 and 1220, the light emitting diode module may be disposed in contact with the heat sink in a way that the holes are made to sequentially pass through the first and second printed circuit boards 1210 and 1220 through the portion of the structure of the heat sink.

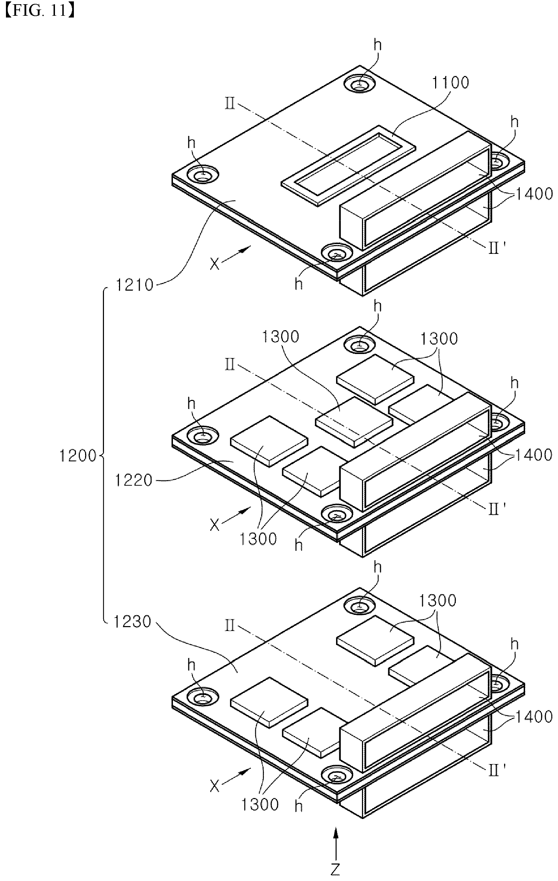

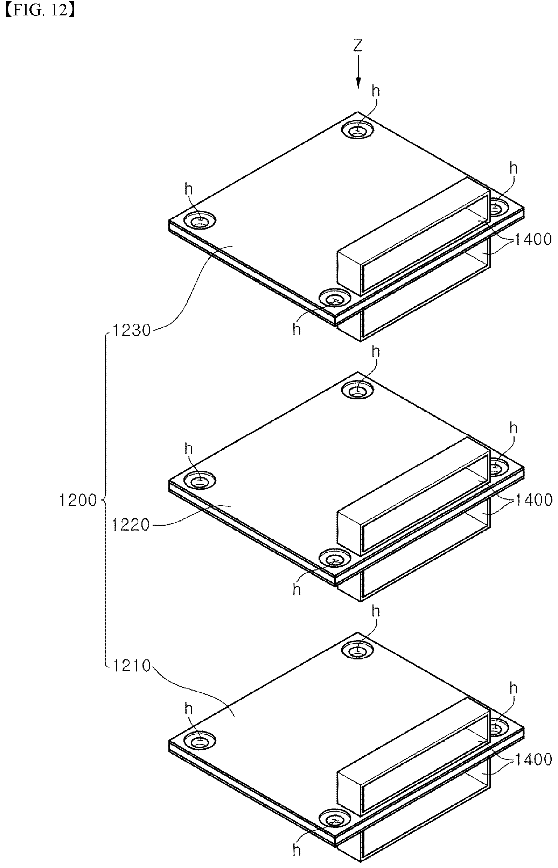

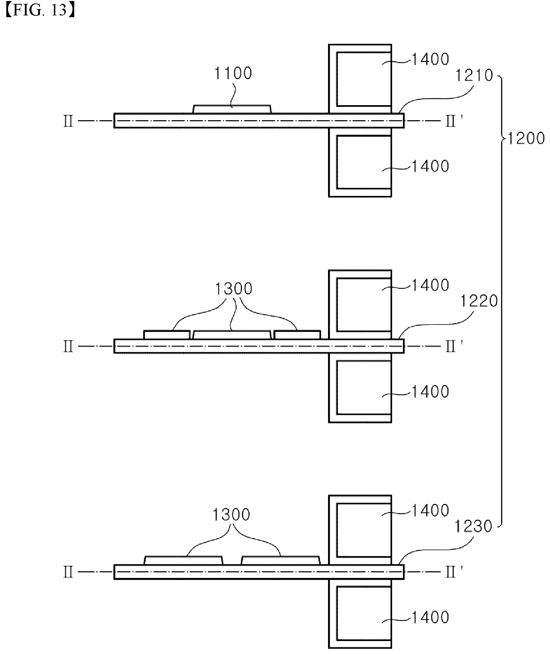

FIG. 11 is a view of a light emitting diode module according to a sixth embodiment of the present disclosure, FIG. 12 is a view of the light emitting diode module shown in FIG. 11 viewed from a bottom (Z direction), and FIG. 13 is a view of a cross section (II-II' direction) of the light emitting diode module shown in FIG.11 viewed from an X direction.

Referring to FIGs. 11 through 13, the light emitting diode module according to the sixth embodiment of the present disclosure includes 3 printed circuit boards 1200 unlike the fifth embodiment. Hereinafter, differences from the fifth embodiment will be mainly described.

A light emitting diode package 1100 is disposed on a first printed circuit board 1210, and preferably, the light emitting diode package 1100 is disposed in a central portion of the first printed circuit board 1210. A connector 1400 is disposed on one edge of the first printed circuit board 1210, and a plurality of holes h passing through the first printed circuit board 1210 is formed in the first printed circuit board 1210. It is preferable that the plurality of holes h is formed near corners of the first printed circuit board 1210, respectively.

Portions of a plurality of driving chips 1300 are disposed on a second printed circuit board 1220 under the first printed circuit board 1210, and for example, in a case that 9 driving chips 1300 are required to drive the light emitting diode package 1100, 5 driving chips 1300 may be disposed on the second printed circuit board 1220. The connector 1400 is disposed on one edge of the second printed circuit board 1220, and a plurality of holes h passing through the second printed circuit board 1220 is formed in the second printed circuit board 1220. It is preferable that the plurality of holes h is formed near corners of the second printed circuit board 1220, respectively.

Remaining portion of the plurality of driving chips 1300 are disposed on a third printed circuit board 1230 under the second printed circuit board 1220, and for example, in a case that 9 driving chips 1300 are required to drive the light emitting diode package 1100, remaining 4 driving chips 1300 may be disposed on the third printed circuit board 1230. It is preferable that the plurality of driving chips 1300 is distributed and disposed on the plurality of printed circuit boards 1200 as much as possible.

The connector 1400 is disposed on one edge of the third printed circuit board 1230, and a plurality of holes h passing through the third printed circuit board 1230 is formed in the third printed circuit board 1230. It is preferable that the plurality of holes h is formed near corners of the third printed circuit board 1230, respectively.

The hole h formed in the first printed circuit board 1210, the hole h formed in the second printed circuit board 1220, and the hole h formed in the third printed circuit board 1230 are penetrated by a bolt or the like and the first through third printed circuit boards 1210, 1220, and 1230 are secured in a state that they are spaced apart.

A distance between the printed circuit boards 1210, 1220, and 1230 may be adjusted by adjusting a length of the bolt or the like between the printed circuit boards 1210, 1220 and 1230. Since a portion that generates the most heat is the light emitting diode package 1100, a distance between the first and second printed circuit boards 1210 and 1220 may be formed longer than a distance between the second and third printed circuit boards 1220 and 1230. Considering heat spread, the distance between the first and second printed circuit boards 1210 and 1220 and the distance between the second and third printed circuit boards 1220 and 1230 are preferably 3mm to 20mm, respectively.

In addition, by adjusting positions of the hole h formed in the first printed circuit board 1210, the hole h formed in the second printed circuit board 1220, and the hole h formed in the third printed circuit board 1230, arrangements of the first through third printed circuit boards 1210, 1220, and 1230 may be adjusted. When two or more of the first through third printed circuit boards 1210, 1220, and 1230 are arranged such that edges thereof are in an oblique line, it is more favorable to dissipate generated heat compared to a case where the first through third printed circuit boards 1210, 1220, and 1230 are all arranged such that edges thereof are flush with one another vertically.

By forming holes through which a portion of a structure of a heat sink can pass in the first through third printed circuit boards 1210, 1220, and 1230, the light emitting diode module may be disposed in contact with the heat sink of a headlamp in a way that the holes are made to sequentially pass through the first through third printed circuit boards 1210, 1220, and 1230.

In addition, it is preferable that the connector 1400 of the first printed circuit board 1210, the connector 1400 of the second printed circuit board 1220, and the connector 1400 of the third printed circuit board 1230 are disposed in a same direction to efficiently connect cables or others.

The present invention is an invention that forms the printed circuit boards 1200 with small sizes and allows a required number of printed circuit boards 1200 to be disposed over and under or front and rear. The present disclosure may be applied to a headlamp field and a display field where there is a space restriction in a top, bottom, left and right, while there is sufficient space in a front and rear.

According to the present disclosure, by separately disposing the light emitting diode package 1100 and the driving chip 1300 on different substrates, it is possible to form the printed circuit board 1200 small with a size of 1/4 or less compared to that of the prior art, away from a constraint that a distance between the light emitting diode package 1100 and the driving chip 1300 should be maintained at a certain distance or more.

According to the present disclosure, even when many driving chips 1300 are required to drive the light emitting diode package 1100, it is possible to form the small printed circuit board since the driving chips 1300 may be divided and disposed on the plurality of printed circuit boards 1200.

According to the present disclosure, by forming the plurality of printed circuit boards 1200 and arranging the plurality of printed circuit boards 1200 spaced apart, heat spread is performed through a space between the printed circuit boards 1200, and thus, it is very favorable in terms of heat spread compared to that of the prior art that includes only one printed circuit board. When heat spread is performed smoothly, there is an advantage that the performance of the driving chip 1300 may be improved.

In an actual process of manufacturing the headlamp and display, the size of the printed circuit board 1200 ultimately determines sizes of the headlamp and display.

Therefore, according to the present disclosure, since the size of the printed circuit board 1200 may be formed as small as necessary, a degree of freedom in design may be increased and flexibility of design may be provided, and when the present disclosure is applied to a headlamp, an area of a lens of the headlamp may be reduced, and thus, a cost required for the lens may be reduced.

In addition, according to the present disclosure, the degree of freedom in design may be improved by reducing a cross-sectional area of the printed circuit board and enabling the printed circuit board to be arranged in front and rear as much as needed.

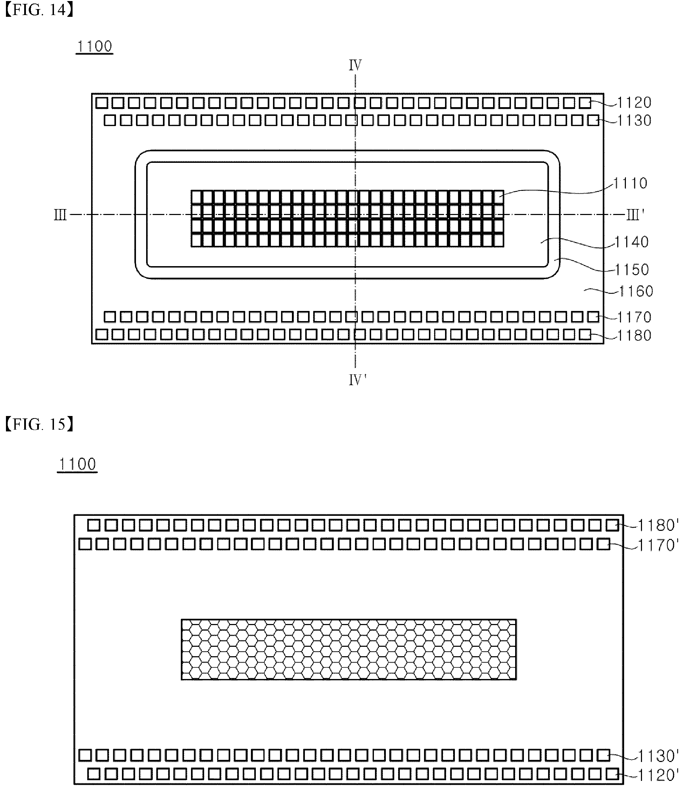

FIG. 14 is an enlarged view of a light emitting diode package of an embodiment applied to the light emitting diode module of the present disclosure.

Referring to FIG. 14, a light emitting diode package 1100 of an embodiment applied to the light emitting diode module of the present disclosure includes a plurality of light sources 1110, a first molding member 1140, a second molding member 1150, a first electrode 1120, a second electrode 1130, a third electrode 1170, a fourth electrode 1180, and a substrate 1160.

The plurality of light sources 1110 may be arranged on the substrate 1160 in a matrix array, and may be arranged in N × M (where N is 1 or more, and M is greater than N). The arrangement of the plurality of light sources 1110 may be changed according to a brightness of a light emitting diode chip 1110, a width, a height, and the like of a region of light to be illuminated by a headlamp or display, and for example, as shown in FIG. 14, a total of 112 light sources 1110 may be disposed on the substrate 1160 in a 28 × 4 matrix array.

In addition, the arrangement of the plurality of light sources 1110 may be changed according to a number of light sources 1110 that can be driven by a driving chip 1300. For example, when the driving chip 1300 can drive 12 light sources 1110, 108 light sources 1110 can be driven when 9 driving chips 1300 are installed. 4 light sources may be deleted from the 28 × 4 matrix array.

However, since the present invention includes the plurality of printed circuit boards 1200, it is possible to dispose as many driving chips 1300 as necessary without limiting an area of the printed circuit board 1200. When the number of driving chips 1300 is increased, there is an advantage that control precision is further increased.

According to the prior art including only one printed circuit board 1200, there is no space to additionally dispose the driving chip 1300 unless the size of the printed circuit board 1200 is increased, so it is difficult to increase the number of light sources 1110, whereas according to the present disclosure, the number of light sources 1110 may be sufficiently increased as needed.

The first molding member 1140 is formed on the substrate 1160 around the light source 1110 and serves to protect the light source 1110 and block unnecessary portions of light emitted from the light source 1110. The first molding member 1140 is not only formed along an outer periphery of the plurality of light sources 1110, but also formed between each of light sources 1110.

A portion formed along the outer periphery of the plurality of light sources 1110 of the first molding member 1140 is formed relatively wide, a lateral length a may be formed to be 5 times or less than a lateral length of the light source, and a vertical length b may be formed to be 3 times or less than a vertical length of the light source.

In addition, a portion formed between each of light sources 1110 of the first molding member 1140 is relatively narrow, preferably formed with a small width of 30µm to 150µm, and thus, may fill the plurality of light sources 1110 in a matrix arrangement in a checkerboard pattern.

In a case that the portion formed between each of light sources 1110 of the first molding member 1140 exceeds 150µm, a dark spot may occur between light sources 1110, and in a case that it is smaller than 30µm, light interference may occur during illumination, and thus, it is preferable that the width of the portion formed between each of light sources 1110 of the first molding member 1140 is in a range of 30µm to 150µm.

Since the first molding member 1140 is also formed between each of light sources 1110, when there is a vehicle or pedestrian in front and light intensities of some of light sources 1110 are lowered or some of them are turned off, interference with light emitted from other light sources 1110 may be reduced, and thus, a contrast ratio may be increased.

The first molding member 1140 may be made of silicone, and may be white or black to be effective in blocking or reflecting light, without being limited thereto.

The second molding member 1150 is formed on the substrate 1160 to surround the first molding member 1140 with a predetermined thickness. The second molding member 1150 serves to prevent leakage of light irradiated from light sources 1110, and it is preferable that a width of the second molding member 1150 is 0.5 times or more and 3 times or less than the width of the light source 1110.

The second molding member 1150 serves as a dam to limit a region where the first molding member 1140 is to be formed such that the first molding member 1140 that has not yet hardened does not overflow when the light emitting diode package 1100 is manufactured. Therefore, a height of the second molding member 1150 (direction away from the substrate 1160, hereinafter the same) may be greater than that of the first molding member 1140.

In addition, the second molding member 1150 serves as a boundary for light to prevent light emitted from the light source 1110 from being reflected by the second molding member 1150 and spreading to the substrate 1160.

A material and a color of the second molding member 1150 may be same as or different from those of the first molding member 1140. For example, the first molding member 1140 may be made of light reflective silicone, and the second molding member 1150 may be made of silicone having a different chroma from that of the first molding member 1140.

The first electrode 1120, the second electrode 1130, the third electrode 1170, and the fourth electrode 1180 are disposed on the substrate 1160. Each of the electrodes 1120, 1130, 1170, and 1180 may be formed in plurality, and as shown in FIG. 14, the plurality of first through fourth electrodes 1120, 1130, 1170, and 1180 may be arranged in a row, respectively.

In addition, the first electrode 1120 and the second electrode 1130 are disposed opposite to the third electrode 1170 and the fourth electrode 1180 with respect to the light source 1110 and the molding members 1140 and 1150, the plurality of first electrodes 1120 arranged in a row and the plurality of second electrodes 1130 arranged in a row may be arranged parallel on one edge of the substrate 1160, and the plurality of the third electrodes 1170 arranged in a row and the plurality of fourth electrodes 1180 arranged in a row may be arranged parallel on an opposite edge of the substrate 1160.

The first electrode 1120 and the second electrode 1130 have different polarities, and for example, the first electrode 1120 may be an anode and the second electrode 1130 may be a cathode. In addition, the third electrode 1170 and the fourth electrode 1180 have different polarities, and for example, the third electrode 1170 may be a cathode and the fourth electrode 1180 may be an anode.

The substrate 1160 is preferably formed of a material favorable to heat spread, and may be a material including ceramic, or may be aluminum nitride (AlN), or a silicon substrate used in semiconductors.

FIG. 15 is a view of a rear side of the light emitting diode package shown in FIG. 14.

Referring to FIG. 15, a fifth electrode 1120', a sixth electrode 1130', a seventh electrode 1170', and an eighth electrode 1180' are disposed on a rear side of the substrate 1160. The fifth electrode 1120' may be disposed at a position corresponding to that of the fourth electrode 1180, the sixth electrode 1130' may be disposed at a position corresponding to that of the third electrode 1170, the seventh electrode 1170' may be disposed at a position corresponding to that of the second electrode 1130, and the eighth electrode 1180' may be disposed at a position corresponding to that of the first electrode 1120. In addition, a portion corresponding to a portion where the light source 1110 is disposed may be formed in a honeycomb shape.

The fifth electrode 1120' and the sixth electrode 1130' have different polarities, and for example, the fifth electrode 1120' may have an anode and the sixth electrode 1130' may have a cathode. In addition, the seventh electrode 1170' and the eighth electrode 1180' have different polarities, and for example, the seventh electrode 1170' may have a cathode and the eighth electrode 1180' may have an anode.

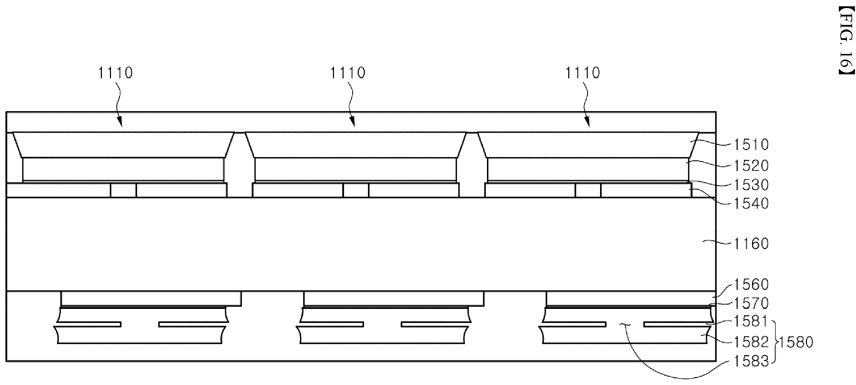

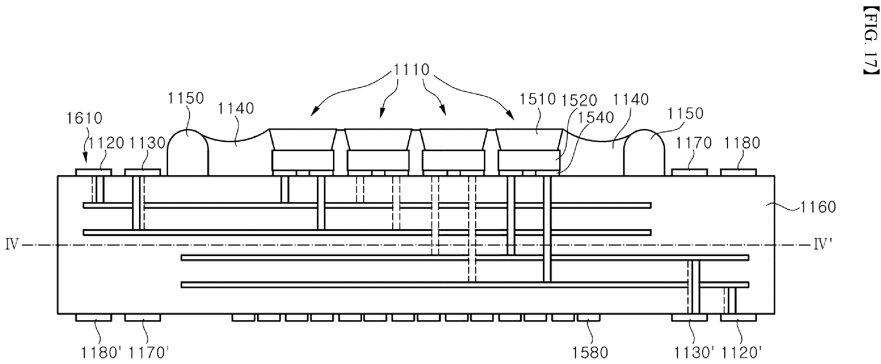

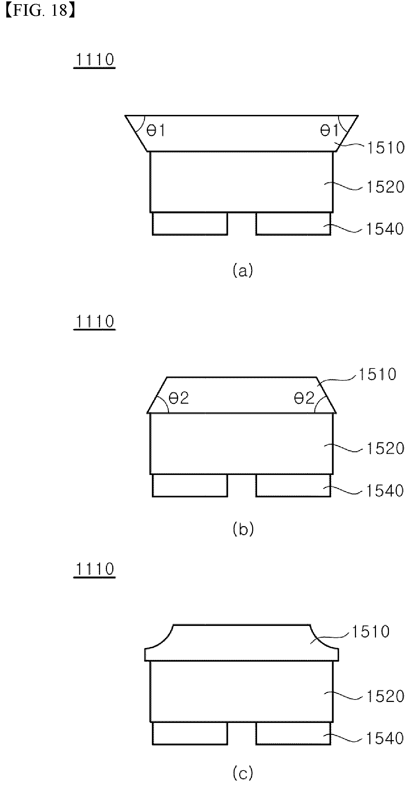

FIG. 16 is a view of a portion of a cross section of the light emitting diode package shown in FIG. 14 cut in a lateral direction (III-III' direction), FIG. 17 is a cross-sectional view of the light emitting diode package shown in FIG. 14 cut in a vertical direction (IV-IV' direction), and FIG. 18 illustrates various forms of a cover portion applied to the light emitting diode module of the present disclosure. In FIG. 16, interconnections inside the substrate 1160 are omitted.

Referring to FIGs. 16 and 17, the light source 1110 applied to the light emitting diode module of the present disclosure includes a light emitting diode chip 1520 and a cover portion 1510 disposed on the light emitting diode chip 1520.

For example, the light emitting diode chip 1520 may emit light having a peak wavelength in a wavelength range of 420nm to 500nm. When the light emitting diode module of the present disclosure includes a plurality of light emitting diode chips 1520, two or more of the plurality of light emitting diode chips 1520 may emit light having different peak wavelengths from one another. As such, when the plurality of light emitting diode chips 1520 emits light having different peak wavelengths, the present disclosure may be suitably applied to a display, without being limited thereto.

The cover portion 1510 serves to cover the light emitting diode chip 1520. The cover portion 1510 may include a wavelength conversion material to convert light emitted from the light emitting diode chip 1520 into a desired wavelength, but the inventive concepts are not limited thereto, and the cover portion 1510 may be a light-transmitting material that does not include a wavelength conversion material, or the present disclosure may not include the cover portion 1510.

Light emitted from the light emitting diode chip 1520 may pass through the cover portion 1510 to be converted into white light. Meanwhile, when two or more of the plurality of light emitting diode chips 1520 emit light having different peak wavelengths, the cover portion 1510 may be a light-transmitting material that does not include a wavelength conversion material, or the present disclosure may not include the cover portion 1510.

The cover portion 1510 may be a phosphor, and more specifically, may be any one of Phosphor in Glass (PIG), Phosphor in Silicone (PIS), Phosphor Ceramic (PC), molding, resin, and phosphor sheet.

Referring to FIG. 18, the cover portion 1510 may be formed in various shapes. That is, it may have a trapezoidal side cross-section with a longer upper side as shown in FIG. 18 (a), may have a trapezoidal side cross-section with a loner lower side as shown in FIG. 18 (b), or may have a side cross-section of a shape in which both upper corners of a rectangle are rounded off as shown in FIG. 18 (c).

When the cover portion 1510 has the shape of the trapezoidal side cross-section with the longer upper side as shown in FIG. 18 (a), light emitted from the light emitting diode chip 1520 is reflected on an obliquely formed sidewall portion, and thus, there is an advantage that an overall amount of light is increased. It is preferable that an angle θ1 formed between the side wall and an upper surface is 50 degrees or more and less than 90 degrees such that a sufficient contrast ratio can be secured while increasing the amount of light.

When the cover portion 1510 has the shape of the trapezoidal side cross-section with the longer lower side as shown in FIG. 18 (b), since an upper surface of the cover portion 1510 has an area smaller than that of an upper surface of a light exiting surface of the light emitting diode chip 1520, there is an advantage that a loss of light amount may be reduced because the light amount can be irradiated in a concentrated manner. It is preferable that an angle θ2 formed between the side wall and a lower surface is 50 degrees or more and less than 90 degrees.

When the cover portion 1510 has the side cross-section of the rectangular shape in which both upper corners are rounded off as shown in FIG. 18 (c), since light incident at a wide angle from the light emitting diode chip 1520 can be concentrated by a curved surface of a rounded corner, there is an advantage that a loss of light amount may be reduced because the light amount can be irradiated in a concentrated manner.

Referring back to FIGs. 16 and 17, a first terminal 1540 is disposed on an upper surface of the substrate 1160 and a second terminal 1560 is disposed on a lower surface of the substrate 1160.

The light source 1110 is disposed on the first terminal 1540, and the first terminal 1540 is connected to the light emitting diode chip 1520. Two first terminals 1540 of different polarities may be connected to each of light sources 1110, and a first adhesive layer 1530 may be disposed between the first terminal 1540 and the light emitting diode chip 1520.

A third terminal 1580 is disposed under the second terminal 1560, and the second terminal 1560 is connected to the third terminal 1580. One second terminal 1560 may be connected to one third terminal 1580, and a second adhesive layer 1570 may be disposed between the second terminal 1560 and the third terminal 1580.

The third terminal 1580 includes a conductive layer 1582, an insulation layer 1581, and a contact hole 1583. The conductive layer 1582 includes an upper conductive layer and a lower conductive layer, and the insulation layer 1581 is disposed between the upper conductive layer and the lower conductive layer. The contact hole 1583 is formed in the insulation layer 1581 and the upper conductive layer and the lower conductive layer are connected through the contact hole 1583.

The conductive layer 1582 of the first terminal 1540, the second terminal 1560, and the third terminal 1580 may be preferably copper plated, the first adhesive layer 1530 and second adhesive layer 1570 may preferably be an Au-Sn alloy, and the insulation layer 1581 of the third terminal 1580 may be a polyimide film, without being limited thereto.

The light emitting diode module of the present disclosure is interconnected such that the plurality of light sources 1110 is individually driven. It may be configured to directly turn on and off power for each of light sources 1110, or it may be configured to select and switch a light source among the plurality of light sources 1110 to be turned on or off using a thin film transistor (TFT) or the like, and then to apply power as a whole.

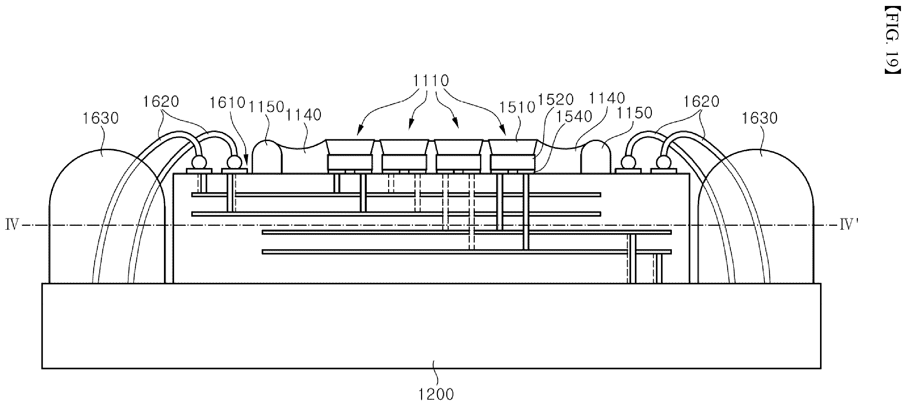

FIG. 19 is a cross-sectional view of the light emitting diode package shown in FIG. 14 cut in the vertical direction (IV-IV' direction) and illustrates a first embodiment of a printed circuit board. The detailed descriptions of the above configuration will be omitted.

In this embodiment, a wire 1620 connects the substrate and the printed circuit board 1200 through the terminals of the light emitting diode package, and a protection member 1630 covering the wire 1620 is disposed on the printed circuit board 1200 on both sides of the substrate. The protection member 1630 may have a dome shape, and may have a height greater than that of the substrate and lower than those of the second molding member 1150 and the light source 1110. In addition, a width of the protection member 1630 may be formed to be greater than that of the light emitting diode chip 1520, and preferably, it may be twice or more than a width of the light emitting diode chip 1520.

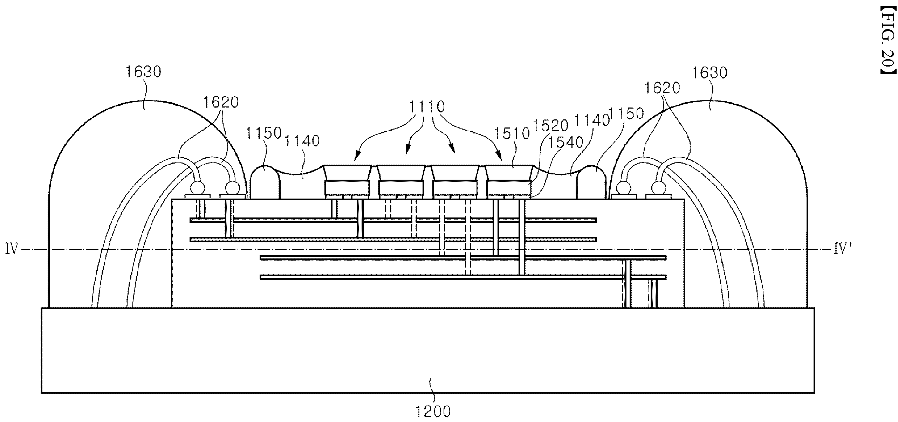

FIG. 20 is a cross-sectional view of the light emitting diode package shown in FIG. 14 cut in the vertical direction (IV-IV' direction) and illustrates a second embodiment of the printed circuit board. Hereinafter, differences from the first embodiment will be mainly described.

Unlike the protection member 1630 of the first embodiment, a protection member 1630 of this embodiment completely covers the wire 1620, and thus, extends to a portion of the substrate to cover a portion of the substrate. A height of the protection member 1630 of this embodiment is formed greater than those of the second molding member 1150 and the light source 1110. In addition, a width of the protection member 1630 may be formed greater than that of the light emitting diode chip 1520, and preferably, it may be 0.5 times or more and 5 times or less than the width of the light emitting diode chip 1520.

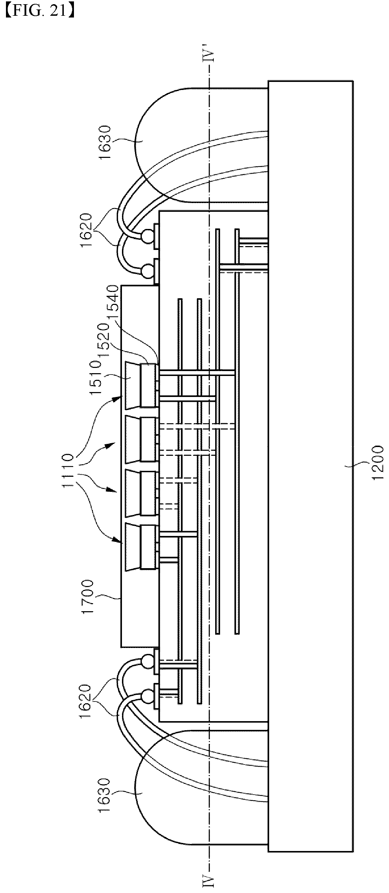

FIG. 21 is a cross-sectional view of the light emitting diode package shown in FIG. 14 cut in the vertical direction (IV-IV' direction) and illustrates a third embodiment of the printed circuit board. Hereinafter, differences from the first embodiment will be mainly described.

The light emitting diode package of this embodiment further includes a reflection member 1700 covering the light source 1110. A region of the reflection member 1700 disposed over the cover portion 1510 may be formed to have a thickness smaller than that of the cover portion 1510. Since a partial region of the reflection member 1700 is formed on an upper surface of the cover portion 1510 with a thickness smaller than that of the cover portion 1510, it has light transmittance for light emitted from a lower light emitting diode chip 1520 and serves to reflect light for light emitted from an adjacent light emitting diode chip 1520 on the side, and thus, it allows light to be clearly emitted only from turned on devices. The thickness of the region of the reflection member 1700 disposed over the cover portion 1510 may be 100µm or less.

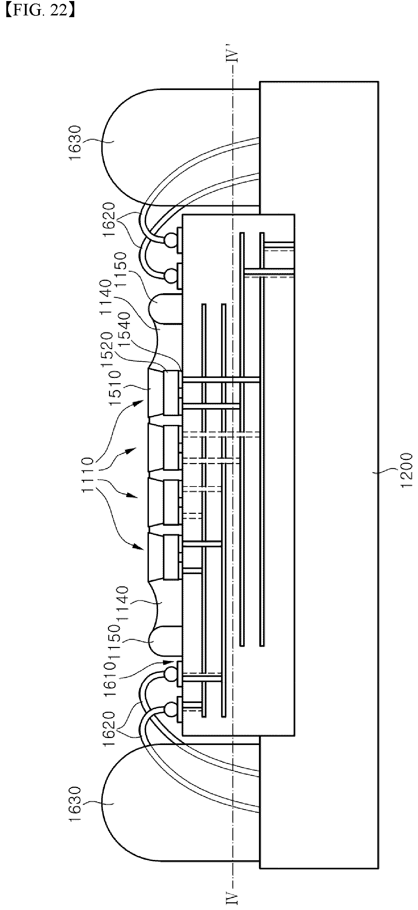

FIG. 22 is a cross-sectional view of the light emitting diode package shown in FIG. 14 cut in the vertical direction (IV-IV' direction) and illustrates a fourth embodiment of the printed circuit board. Hereinafter, differences from the first embodiment will be mainly described.

In this embodiment, a partial region of the printed circuit board 1200 is recessed, the light emitting diode package is disposed in a recessed region of the printed circuit board 1200, and the protection member 1630 is disposed in a non-recessed region of the printed circuit board 1200.

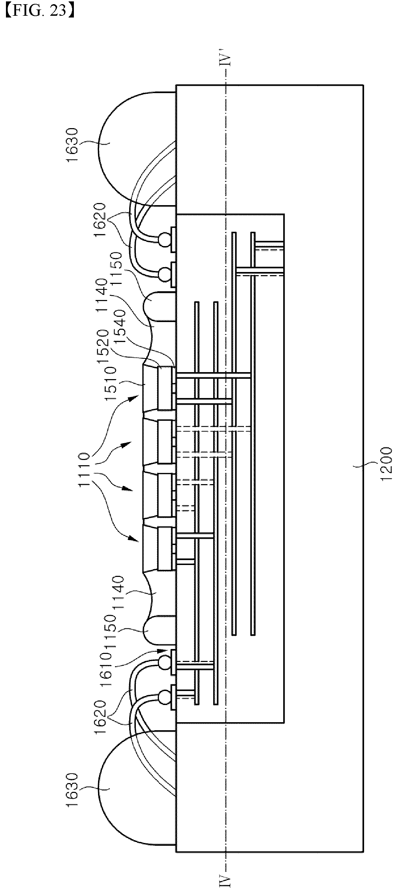

FIG. 23 is a cross-sectional view of the light emitting diode package shown in FIG. 14 cut in the vertical direction (IV-IV' direction) and illustrates a fifth embodiment of the printed circuit board. Hereinafter, differences from the fourth embodiment will be mainly described.

In this embodiment, the printed circuit board 1200 is recessed more deeply than in the fourth embodiment, and thus, a height of an upper surface of the non-recessed region of the printed circuit board 1200 is substantially same as that of the substrate. That is, after the printed circuit board 1200 is recessed by the height corresponding to the substrate, the light emitting diode package is disposed in the recessed region of the printed circuit board 1200.

As shown in FIGs. 22 and 23, when a portion or all of the substrate is disposed to be buried in the printed circuit board 1200, an overall thickness of the module may be reduced, a step difference of a connection portion of the wire 1620 may be reduced, and it is possible to better protect the substrate. In addition, since a contact area between the substrate and the printed circuit board 1200 is increased and a distance between the substrate and a heat sink disposed under the printed circuit board 1200 is shortened, it is favorable to heat spread.

Meanwhile, as shown in FIG. 23, rather than completely burying the substrate in the printed circuit board 1200, a difficulty of a process is lowered when only the portion of the substrate is buried in the printed circuit board 1200 as shown in FIG. 22.

According to the present disclosure, without configuring the printed circuit board 1200 and the substrate 1160 separately, the light source 1110 may be directly mounted on the printed circuit board 1200 after all necessary interconnections are provided on the printed circuit board 1200.

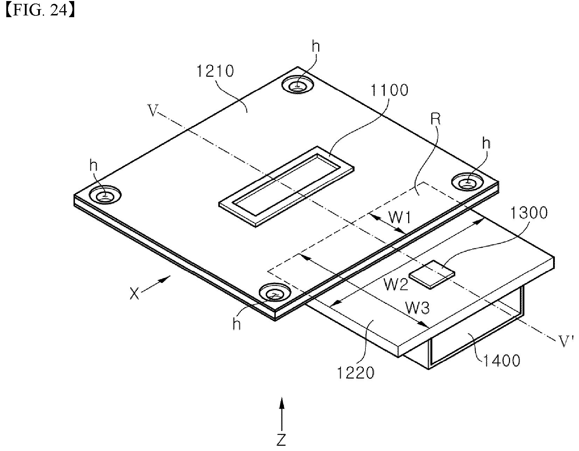

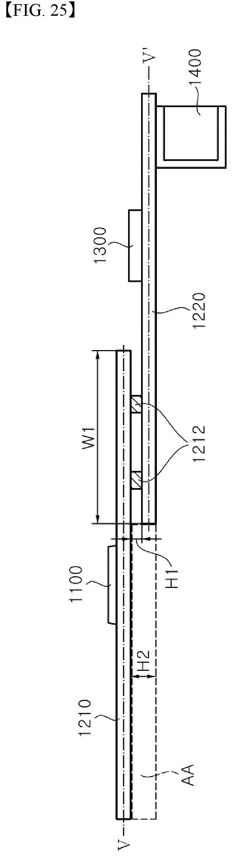

FIG. 24 is a schematic perspective view illustrating a light emitting diode module according to a seventh embodiment of the present disclosure, and FIG. 25 is a schematic cross-sectional view taken along line V-V' of FIG. 24.

Referring to FIGs. 24 and 25, the light emitting diode module according to the seventh embodiment of the present disclosure is substantially similar to the light emitting diode module of the fourth embodiment described with reference to FIGs. 8 to 10, except that printed circuit boards 1210 and 1220 are disposed to partially overlap and electrically connected to each other by an interconnector 1212. In addition, as the printed circuit boards 1210 and 1220 are electrically connected by the interconnector 1212, the connectors 1400 for connecting them may be removed.

A plurality of holes h passing through a first printed circuit board 1210 are formed in the first printed circuit board 1210, and preferably, the plurality of holes h may be formed near corners of the first printed circuit board 1210, respectively. However, in this embodiment, when the first printed circuit board 1210 and a second printed circuit board 1220 are bonded by the interconnector 1212, there is no need to couple the printed circuit boards 1210 and 1220 to each other using a bolt, or the like, and thus, the holes h may be omitted.

A driving chip 1300 may be disposed on the second printed circuit board 1220. Although one driving chip 1300 is illustrated, a desired number of driving chips 1300 may be disposed to drive a light emitting diode package 1100. Alternatively, the driving chip 1300 may be omitted.

A connector 1400 is disposed on one edge of the second printed circuit board 1220. The connector 1400 may be disposed on a same side as the driving chip 1300, or may be disposed on both sides of the second printed circuit board 1220. The connector 1400 may be provided with a conductive material for electrical connection.

As shown in FIG. 25, in this embodiment, the first printed circuit board 1210 and the second printed circuit board 1220 are disposed to partially overlap with each other. The interconnector 1212 is disposed between the first printed circuit board 1210 and the second printed circuit board 1220 in an overlapping region R. The interconnector 1212 may be, for example, a bonding material such as solder, or a connection pin such as a pogo pin.

The light emitting diode package 1100 may be spaced apart from the overlapping region R, or at least one light emitting diode package 1100 may be disposed over the overlapping region R.

The interconnector 1212 electrically connects a circuit of the first printed circuit board 1210 and a circuit of the second printed circuit board 1220 to each other. Since the first printed circuit board 1210 and the second printed circuit board 1220 are electrically connected by the interconnector 1212, the connectors 1400 for connecting them may be omitted.

As the first printed circuit board 1210 and the second printed circuit board 1220 partially overlap, height levels of the first printed circuit board 1210 and the second printed circuit board 1220 are different from each other. Accordingly, an air movement region AA may be formed in a region that does not overlap with the second printed circuit board 1220 among a lower region of the first printed circuit board 1210.

An upper surface area of the first printed circuit board 1210 is larger than that of the second printed circuit board 1220. By making the first printed circuit board 1210 relatively large, an area in contact with air may be increased. In addition, the upper surfaces of the first printed circuit board 1210 and the second printed circuit board 1220 may have different shapes. The second printed circuit board 1220 overlaps with the first printed circuit board 1210 over its entire length in an X direction, and partially overlaps with the first printed circuit board 1210 in a width direction perpendicular to the X direction. A width W1 of the second printed circuit board 1220 overlapping with the first printed circuit board 1210 in the width direction is smaller than a length W2 of the second printed circuit board 1220 in the X direction. In addition, an overall length W3 of the second printed circuit board 1220 in the width direction is greater than an overall length W2 of the second printed circuit board 1220 in the X direction.

Meanwhile, in the region where the first printed circuit board 1210 and the second printed circuit board 1220 overlap, a distance between a lower surface of the first printed circuit board 1210 and the upper surface of the second printed circuit board 1220, that is, a first height H1, is smaller than a thickness of the first printed circuit board 1210, and smaller than a thickness of the second printed circuit board 1220. The width W1 of the region where the first printed circuit board 1210 and the second printed circuit board 1220 overlap in the width direction is greater than the first height H1.

A height H2 of the air movement region AA is greater than the thickness of the first printed circuit board 1210 or the second printed circuit board 1220, and smaller than a sum of the thicknesses of the first printed circuit board 1210 and the second printed circuit board 1220.

A reflectance of the upper surface of the first printed circuit board 1210 may be different from that of the upper surface of the second printed circuit board 1220. For example, a reflection layer may be formed on the upper surface of the first printed circuit board 1210.

In this embodiment, the driving chip 1300 has been described as being disposed on the second printed circuit board 1220, but the second printed circuit board 1220 is employed to provide the air movement region AA, and the driving chip 1300 is not necessarily disposed on the printed circuit board 1220. For example, the driving chip 1300 may be disposed on the first printed circuit board 1210 like the light emitting diode module according to the fourth embodiment of FIG. 7, and may be disposed on a printed circuit board other than the second printed circuit board 1220 (for example, 1230 in FIG. 11).

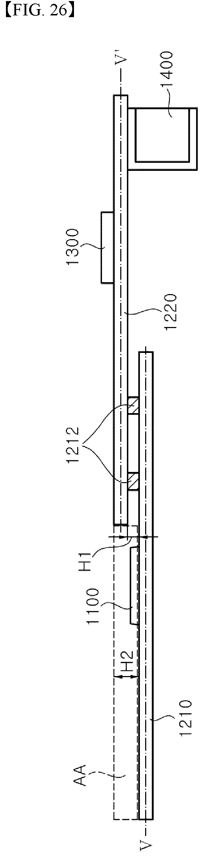

Meanwhile, relative positions of the first printed circuit board 1210 and the second printed circuit board 1220 may be changed. For example, as shown in FIG. 26, the first printed circuit board 1210 may be disposed under the first printed circuit board 1220, and the air movement region AA may be formed on an upper side of the first printed circuit board 1210.

A distance between the upper surface of the first printed circuit board 1210 and the lower surface of the second printed circuit board 1220 in the region where the first printed circuit board 1210 and the second printed circuit board 1220 overlap, that is, the first height H1, is smaller than the thickness of the first printed circuit board 1210, and smaller than the thickness of the second printed circuit board 1220. The width W1 of the region where the first printed circuit board 1210 and the second printed circuit board 1220 overlap in the width direction is greater than the first height H1.

The height H2 of the air movement region AA is greater than the thickness of the first printed circuit board 1210 or the second printed circuit board 1220, and smaller than the sum of the thicknesses of the first printed circuit board 1210 and the second printed circuit board 1220.

The reflectance of the upper surface of the first printed circuit board 1210 may be different from that of the upper surface of the second printed circuit board 1220. For example, a reflection layer may be formed on the upper surface of the first printed circuit board 1210.

The inventive concepts are not limited to the above exemplary embodiments, and it is obvious to those skilled in the art that various modifications or variations can be implemented without departing from the technical scope of the present disclosure.

## Claims

1. A light emitting diode module, comprising:
a first substrate; and
a second substrate disposed in one direction of the first substrate,
the first substrate, comprising:
a light emitting diode package in which at least one or more light emitting units that generate and emit light are disposed, wherein:
the light emitting diode package includes a dam portion formed to surround the light emitting unit, and
the first substrate and the second substrate include an overlapping region where they overlap with each other.

2. The light emitting diode module of claim 1, further comprising:
a first connector on the first substrate for receiving external power.

3. The light emitting diode module of claim 1, further comprising:
a second connector on the second substrate to electrically connect the first substrate.

4. The light emitting diode module of claim 1,
wherein the first substrate and the second substrate are spaced apart at a predetermined interval.

5. The light emitting diode module of claim 1, further comprising:
at least one or more driving controllers that drive the light emitting diode package,
wherein the light emitting diode package and the driving controller are disposed to overlap vertically.

6. The light emitting diode module of claim 1, further comprising:
a fixer that connects and secures the first substrate and the second substrate.

7. The light emitting diode module of claim 1, further comprising a first light control layer that fills a space between the light emitting unit and the dam portion.

8. The light emitting diode module of claim 7,
wherein the first light control layer includes a material that reflects light.

9. The light emitting diode module of claim 7,
wherein an upper surface of the first light control layer has a concave shape.

10. The light emitting diode module of claim 1,
wherein the light emitting unit and the dam portion have a same height.

11. The light emitting diode module of claim 1,
wherein the dam portion has a height higher than that of the light emitting unit.

12. The light emitting diode module of claim 1,
wherein the light emitting unit is disposed in a plural number in rows and columns to form a matrix beam.

13. The light emitting diode module of claim 12,
the light emitting units disposed in the plural number, comprising:
a first light emitting unit and a second light emitting unit,
wherein the light emitting diode module comprises a second light control unit filling a space between the first light emitting unit and the second light emitting unit.

14. The light emitting diode module of claim 13,
wherein the second light control unit includes a material that reflects light.

15. The light emitting diode module of claim 1, wherein:
the light emitting unit includes,
a light transmitting portion containing a wavelength conversion material, and
a side surface of the light transmitting portion includes an inclined surface.

16. The light emitting diode module of claim 1, wherein:
the first substrate and the second substrate are disposed along a first direction, and
a length of the overlapping region in the first direction is smaller than a length of the second substrate in a second direction perpendicular to the first direction.

17. The light emitting diode module of claim 1, wherein:
the first substrate and the second substrate are disposed along the first direction, and
a length of the second substrate in the first direction is greater than that of the second substrate in the second direction perpendicular to the first direction.

18. The light emitting diode module of claim 1,
wherein a distance between one surface of the first substrate and one surface of the second substrate opposite to the one surface in the overlapping region is smaller than a thickness of the first substrate.

19. The light emitting diode module of claim 1,
wherein a reflectance of one surface of the first substrate is different from that of one surface of the second substrate.

20. The light emitting diode module of claim 1, further comprising:
an interconnector disposed in the overlapping region, wherein the interconnector includes a conductive material.
